(19) **Europäisches Patentamt / European Patent Office / Office européen des brevets**

(11) **EP 3 090 536 B1**

(12) **FASCICULE DE BREVET EUROPEEN**

(45) Date de publication et mention de la délivrance du brevet:
**11.03.2020 Bulletin 2020/11**

(51) Int Cl.:
***H04N 5/30*** *(2006.01)*    ***H03M 3/00*** *(2006.01)*
***G03H 1/04*** *(2006.01)*

(21) Numéro de dépôt: **14814840.6**

(22) Date de dépôt: **16.12.2014**

(86) Numéro de dépôt international:
**PCT/EP2014/078019**

(87) Numéro de publication internationale:
**WO 2015/101482 (09.07.2015 Gazette 2015/27)**

(54) **SYSTEME D'ACQUISITION D'IMAGES PAR HOLOGRAPHIE NUMERIQUE HETERODYNE**

SYSTEM ZUR ERFASSUNG VON BILDERN MITTELS HETERODYNER DIGITALER HOLOGRAFIE

SYSTEM FOR ACQUIRING IMAGES BY MEANS OF HETERODYNE DIGITAL HOLOGRAPHY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **31.12.2013 FR 1363761**

(43) Date de publication de la demande:
**09.11.2016 Bulletin 2016/45**

(73) Titulaire: **Commissariat à l'Energie Atomique et aux Energies Alternatives**
**75015 Paris (FR)**

(72) Inventeurs:
• **LAFOREST, Timothé**
  **F-71220 Sivignon (FR)**
• **DUPRET, Antoine**
  **F-91400 Orsay (FR)**
• **VERDANT, Arnaud**
  **38330 Saint Nazaire Les Eymes (FR)**

(74) Mandataire: **Cabinet Beaumont**
**4, Place Robert Schuman**
**B.P. 1529**
**38025 Grenoble Cedex 1 (FR)**

(56) Documents cités:
**US-B1- 6 262 818**

• SALMA FARAHI ET AL: "Time resolved three-dimensional acousto-optic imaging of thick scattering media", OPTICS LETTERS, OPTICAL SOCIETY OF AMERICA, US, vol. 37, no. 13, 1 juillet 2012 (2012-07-01), pages 2754-2756, XP001577006, ISSN: 0146-9592, DOI: 10.1364/OL.37.002754 [extrait le 2012-06-29]
• CLERC LE F ET AL: "NUMERICAL HETERODYNE HOLOGRAPHY WITH TWO-DIMENSIONAL PHOTODETECTOR ARRAYS", OPTICS LETTERS, OPTICAL SOCIETY OF AMERICA, US, vol. 25, no. 10, 15 juin 2000 (2000-06-15), pages 716-718, XP000951919, ISSN: 0146-9592 cité dans la demande
• LISA A. MCILRATH ET AL: "<title>Architecture for low-power real-time image analysis using 3D silicon technology</title>", PROCEEDINGS OF SPIE, vol. 3362, 11 août 1998 (1998-08-11), pages 184-195, XP055123425, ISSN: 0277-786X, DOI: 10.1117/12.317431

## Description

La présente demande de brevet revendique la priorité de la demande de brevet français FR13/63761.

Domaine

La présente demande concerne le domaine de l'acquisition d'images, et vise plus particulièrement un système d'acquisition d'images par holographie numérique hétérodyne.

Exposé de l'art antérieur

On désigne généralement par holographie numérique des techniques permettant d'enregistrer, à l'aide d'un capteur d'images numériques, la phase et l'amplitude d'un faisceau de lumière cohérente après réflexion ou transmission par un objet.

Les techniques d'holographie usuelles sont basées sur l'utilisation des interférences produites par la superposition de deux faisceaux lumineux cohérents, le premier, ou faisceau objet, étant transmis ou réfléchi par l'objet à examiner, et le deuxième, ou faisceau de référence, ne passant pas par l'objet à examiner.

L'holographie hétérodyne est une technique d'holographie dans laquelle le faisceau objet et le faisceau de référence sont légèrement décalés en fréquence. Un exemple de système d'acquisition d'image par holographie numérique hétérodyne est par exemple décrit dans l'article intitulé "Numerical heterodyne holography with two-dimensionnal photodetector arrays" de F. Le Clerc et al.

Il existe un besoin d'améliorer au moins en partie certains aspects des systèmes existants d'acquisition d'images par holographie numérique hétérodyne.

Résumé

Pour cela, un mode de réalisation prévoit un système d'acquisition d'images par holographie numérique hétérodyne, comportant : un capteur d'images ayant au moins une photodiode couplée à un convertisseur analogique-numérique ; et un montage optique permettant de projeter simultanément sur le capteur des premier et deuxième faisceaux lumineux cohérents de fréquences distinctes, dans lequel le convertisseur est adapté à acquérir, à une première fréquence, des échantillons analogiques représentatifs d'un signal de sortie de la photodiode, à produire, à une deuxième fréquence égale à la première fréquence ou à un sous-multiple de la première fréquence, des premiers échantillons numériques d'une première résolution à partir desdits échantillons analogiques, et à fournir, à une troisième fréquence égale à un sous-multiple de la deuxième fréquence, des deuxièmes échantillons numériques de résolution supérieure à la première résolution, générés à partir des premiers échantillons numériques, et dans lequel la première fréquence du convertisseur est égale à un nombre entier n de fois la fréquence de battement du système, c'est-à-dire la valeur absolue de la différence entre les fréquences des premier et deuxième faisceaux.

Selon un mode de réalisation, le montage optique comprend un unique modulateur acousto-optique.

Selon un mode de réalisation, le montage optique ne comprend pas de modulateur acousto-optique, et comprend une source ultrasonore d'excitation d'un objet par lequel passe le deuxième faisceau lumineux.

Selon un mode de réalisation, la source ultrasonore est adaptée à émettre une onde ultrasonore pendant un premier intervalle de temps de durée $\Delta t$, et le convertisseur est adapté à n'acquérir des échantillons représentatifs d'un signal de sortie de la photodiode que pendant un deuxième intervalle de temps de même durée $\Delta t$, décalé temporellement par rapport au premier intervalle de temps.

Selon un mode de réalisation, la source ultrasonore est adaptée à émettre une onde ultrasonore présentant une première séquence aléatoire ou pseudo-aléatoire de sauts de phase de 0 ou $\pi$, et le convertisseur est adapté à recevoir un signal binaire représentatif d'une deuxième séquence de sauts de phase identique à la première séquence mais décalée temporellement par rapport à la première séquence, et à modifier une séquence de traitement des échantillons analogiques en fonction de ce signal binaire.

Selon un mode de réalisation, n est égal à 4.

Selon un mode de réalisation, le convertisseur comprend un bloc d'échantillonnage analogique adapté à acquérir n échantillons analogiques d'un signal de sortie de la photodiode à chaque période de battement du système.

Selon un mode de réalisation, le bloc d'échantillonnage analogique est adapté à effectuer en analogique, à chaque période de battement une ou plusieurs opérations arithmétiques à partir desdits échantillons.

Selon un mode de réalisation, le convertisseur est adapté à fournir, après un nombre entier N de périodes de battement du système, un premier signal numérique sur m bits, représentatif de la partie réelle du champ complexe du deuxième faisceau lumineux, et un deuxième signal numérique sur m bits, représentatif de la partie imaginaire du champ complexe du deuxième faisceau lumineux, où m est un nombre entier supérieur ou égal à 1.

Selon un mode de réalisation, m est égal à $\log_2$.

Selon un mode de réalisation, le convertisseur comprend un intégrateur comportant deux capacités d'intégration.

Selon un mode de réalisation, le convertisseur comprend deux intégrateurs comportant chacun une capacité d'intégration.

Selon un mode de réalisation, le capteur comporte en outre un circuit de filtrage passe-haut entre la photodiode et le convertisseur.

L'invention est définie plus précisément par les revendications ci-jointes.

## Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :

la figure 1 représente de façon schématique un exemple d'un système d'acquisition d'images par holographie numérique hétérodyne ;
la figure 2 est un diagramme illustrant un exemple de fonctionnement du système de la figure 1 ;
la figure 3 représente de façon schématique un autre exemple d'un système d'acquisition d'images par holographie numérique hétérodyne ;
la figure 4 représente de façon schématique un exemple d'un mode de réalisation d'un système d'acquisition d'images par holographie hétérodyne ;
la figure 5 représente de façon schématique un autre exemple d'un mode de réalisation d'un système d'acquisition d'images par holographie hétérodyne ;
les figures 6A et 6B représentent de façon schématique un exemple de réalisation d'un convertisseur analogique-numérique à sur-échantillonnage de type sigma-delta ;
la figure 7 est un diagramme illustrant de façon schématique un exemple de fonctionnement d'un mode de réalisation d'un système d'acquisition d'images par holographie numérique hétérodyne ;
la figure 8 représente de façon schématique et partielle un exemple d'un mode de réalisation d'un capteur d'images d'un système d'acquisition d'images par holographie numérique hétérodyne ;
la figure 9 représente de façon schématique et partielle une variante de réalisation d'un capteur d'images d'un système d'acquisition d'images par holographie numérique hétérodyne ; et
les figures 10 à 12 représentent de façon schématique et partielle d'autres variantes de réalisation d'un capteur d'images d'un système d'acquisition d'images par holographie numérique hétérodyne.

## Description détaillée

Par souci de clarté, de mêmes éléments ont été désignés par de mêmes références aux différentes figures et, de plus, les diverses figures ne sont pas tracées à l'échelle. Par ailleurs, seuls les éléments utiles à la compréhension des modes de réalisation décrits ont été détaillés. En particulier, les diverses utilisations qui peuvent être faites d'un système d'acquisition d'image par holographie numérique hétérodyne n'ont pas été détaillées, les modes de réalisation décrits étant compatibles avec toutes les applications connues de l'holographie numérique hétérodyne.

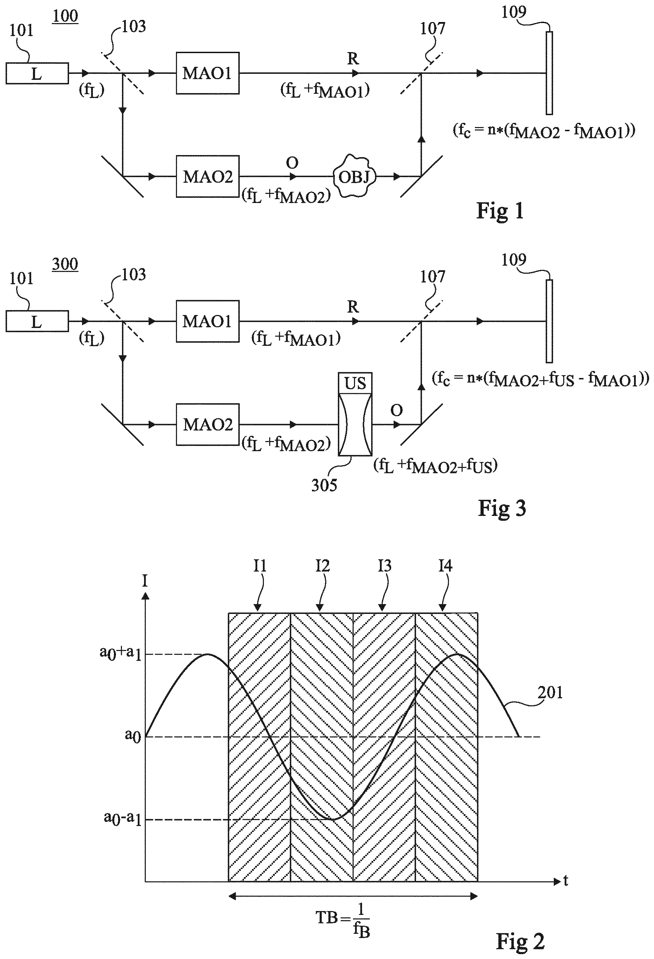

La figure 1 représente de façon schématique un exemple d'un système 100 d'acquisition d'images par holographie numérique hétérodyne.

Le système 100 comprend une source lumineuse 101 (L) adaptée à générer un faisceau lumineux cohérent de fréquence $f_L$, par exemple une source laser. Le système 100 comprend en outre un séparateur 103, par exemple une lame 103 partiellement transparente et partiellement réfléchissante placée à 45 degrés par rapport à la direction d'émission de la source 101, permettant de diviser en deux parties le faisceau produit par la source 101. En sortie du séparateur 103, une première partie de faisceau, ou faisceau de référence R, est modulée par un premier modulateur acousto-optique MAO1 décalant sa fréquence d'une valeur $f_{MAO1}$, et une deuxième partie de faisceau, ou faisceau objet O, est modulée par un deuxième modulateur acousto-optique MAO2 décalant sa fréquence d'une valeur $f_{MAO2}$ différente de la valeur $f_{MAO1}$. Le système est agencé de façon que le faisceau objet, de fréquence $f_L+f_{MAO2}$, illumine un objet 105 (OBJ) à examiner, le faisceau de référence, de fréquence $f_L+f_{MAO1}$, ne passant pas par l'objet 105. Le faisceau de référence et le faisceau objet réfléchi ou transmis par l'objet 105 sont ensuite dirigés vers un élément de recombinaison 107, par exemple une lame partiellement réfléchissante et partiellement transparente qui les recombine. Le faisceau résultant fourni par l'élément 107, comportant à la fois le signal objet et le signal de référence, est projeté sur un capteur d'images 109 comportant une matrice de pixels (non visibles sur la figure 1).

En fonctionnement, le capteur 109 voit une figure d'interférences présentant une fréquence de battement $f_B$ égale à la valeur absolue de la différence de fréquence entre le faisceau objet et le faisceau de référence, c'est-à-dire à la valeur absolue de la différence $f_{MAO2}-f_{MAO1}$.

La figure 2 est un diagramme illustrant plus en détail le principe de fonctionnement du système de la figure 1.

Le diagramme de la figure 2 comprend une courbe 201 représentant l'évolution en fonction du temps de l'intensité lumineuse I reçue par un pixel du capteur 109 du système de la figure 1, lorsque le capteur 109 est éclairé par le faisceau fourni par l'élément 107, combinant le faisceau objet de fréquence $f_L+f_{MAO2}$ et le faisceau de référence de fréquence $f_L+f_{MAO1}$. Comme cela apparaît sur la figure, l'intensité I reçue évolue de façon sinusoïdale autour d'une valeur moyenne ou composante continue $a_0$, avec une amplitude de crête de valeur $a_1$, à une fréquence égale à la fréquence de battement $f_B$ du système. Les intensités lumineuses reçues par différents pixels du capteur 109 peuvent avoir des composantes continues $a_0$ distinctes et/ou des amplitudes $a_1$ distinctes, mais fluctuent toutes de façon sinusoïdale à la fréquence de battement $f_B$, avec des déphasages propres.

Dans cet exemple, la fréquence d'acquisition $f_C$ du capteur d'images 109 est égale à quatre fois la fréquence de battement $f_B$ du système. Ainsi, pour un pixel donné, le capteur 109 fournit quatre valeurs de sortie I1, I2, I3 et I4 en une période de battement $T_B$ = $1/f_B$ du système.

Lorsque quatre valeurs de sorties successives déphasées de $\pi/2$, c'est-à-dire séparées d'un intervalle de temps $T_B/4$, ont été acquises pour chaque pixel du capteur, c'est-à-dire lorsque quatre images successives ont été acquises par le capteur, le champ complexe $E_O$ du faisceau objet reçu par le capteur 109 peut être déterminé, pour chaque pixel du capteur, par la formule $E_O$ = (I1-I3) + j (I2-I4). La composante I1-I3 correspond à la partie réelle du champ $E_O$, et la composante I2-I4 correspond à la partie imaginaire du champ $E_O$. La phase $P_O$ et l'amplitude $A_O$ du signal objet reçu par chaque pixel du capteur peuvent être déterminées par les formules suivantes :

$$P_O = \mathrm{arctan}\left((I2 - I4)/(I1 - I3)\right),$$

et

$$A_O = \sqrt{(I1 - I3)^2 + (I2 - I4)^2}\ .$$

On notera que le ratio n entre la fréquence de battement $f_B$ du système et la fréquence d'acquisition $f_C$ du capteur d'images peut être un nombre entier différent de 4, par exemple n = 2, n = 3, ou n = 5. Dans ce cas, le principe de fonctionnement est similaire à ce qui a été décrit précédemment, c'est-à-dire que, pour chaque pixel, le capteur acquiert n valeurs de sortie déphasées de $2\pi/n$ en une période de battement $T_B$ = $1/f_B$, puis ces valeurs sont utilisées pour déterminer, pixel par pixel, par des formules de calcul adaptées (différentes des formules mentionnées ci-dessus pour le cas n=4), l'amplitude $A_O$ et la phase $P_O$ du faisceau objet reçu par le capteur.

La figure 3 représente de façon schématique un autre exemple d'un système 300 d'acquisition d'images par holographie numérique hétérodyne. Le système 300 comprend des éléments communs avec le système 100 de la figure 1. Seules les différences entre ces deux systèmes seront détaillées ci-après.

Le système 300 comprend, comme le système 100 de la figure 1, une source lumineuse 101, un séparateur 103 adapté à diviser un faisceau fourni par la source 101 en un faisceau objet et un faisceau de référence, un premier modulateur acousto-optique MAO1 adapté à décaler la fréquence du faisceau de référence d'une valeur $f_{MAO1}$, et un deuxième modulateur acousto-optique MAO2 adapté à décaler la fréquence du faisceau objet d'une valeur $f_{MAO2}$. Le système 300 est agencé de façon que le faisceau objet, de fréquence $f_L+f_{MAO2}$, illumine un objet ou échantillon 305 à analyser, et que le faisceau de référence, de fréquence $f_L+f_{MAO1}$, ne passe pas par l'objet 305.

Dans le système 300, une partie de l'objet ou échantillon 305 est excitée par une onde ultrasonore focalisée de fréquence $f_{US}$. Il en résulte que la fréquence des rayons du faisceau objet passant par la partie excitée de l'échantillon est décalée à la valeur $f_L+f_{MAO2}+f_{US}$, alors que la fréquence des rayons du faisceau objet passant par les parties non-excitées de l'échantillon reste à la valeur $f_L+f_{MAO2}$. Ce décalage fréquentiel permet de "marquer" les photons du faisceau objet passés par la partie excitée de l'échantillon par rapport aux autres photons du faisceau objet.

Le faisceau de référence et le faisceau objet sont ensuite dirigés vers un élément de recombinaison 107. Le faisceau résultant fourni par l'élément 107, comportant à la fois le signal objet et le signal de référence, est projeté sur un capteur d'images 109.

Dans le système 300, la fréquence de battement $f_B$ du système est définie comme étant la valeur absolue de la différence de fréquence entre le faisceau de référence et la portion du faisceau objet passée par la partie excitée de l'échantillon 305. Ainsi, la fréquence de battement $f_B$ du système 300 est égale à la valeur absolue de la différence $f_{MAO2}+f_{US}-f_{MAO1}$. La fréquence d'acquisition $f_C$ du capteur d'images 109 est, comme dans l'exemple précédent, égale à n fois la fréquence de battement $f_B$ du système, où n est un nombre entier, par exemple égal à quatre.

Le principe de fonctionnement du système 300 est similaire à ce qui a été décrit précédemment en relation avec les figures 1 et 2, c'est-à-dire que, pour chaque pixel, le capteur acquiert n valeurs de sortie successives déphasées de $2\pi/n$ en une période de battement $T_B$ = $1/f_B$ du système. Ces valeurs de sortie sont ensuite utilisées pour déterminer, pixel par pixel, au moyen de formules de calcul adaptées, le champ complexe de la partie de faisceau objet modulée par l'échantillon 305, et en déduire des informations sur la portion excitée de l'échantillon 305.

Un exemple plus détaillé de réalisation d'un système utilisant la technique du marquage ultrasonore de la lumière combinée avec la technique de l'holographie numérique hétérodyne est décrit dans l'article intitulé "Acousto-Optical Coherence Tomography with a digital holographic détection scheme" de Emilie Benoit a la Guillaume et al.

Un inconvénient des systèmes d'acquisition d'images par holographie numérique hétérodyne du type décrit en relation avec les figures 1 à 3 réside dans la complexité, le coût, et l'encombrement des modulateurs acousto-optiques. De plus, les modulateurs acousto-optiques entrainent une atténuation relativement importante des faisceaux lumineux, ce qui oblige à prévoir une source d'éclairement 101 relativement puissante.

On notera que les modulateurs acousto-optiques usuels peuvent typiquement décaler la fréquence d'un faisceau lumineux d'une valeur de l'ordre de quelques MHz à quelques dizaines de MHz, par exemple d'une valeur comprise entre 5 et 100 MHz. De plus, dans le système de la figure 3, l'excitation ultrasonore d'une partie de l'objet à analyser peut provoquer un décalage de fréquence de la lumière passant par la partie excitée de l'objet d'une valeur comprise entre quelques centaines de kHz et quelques MHz, par exemple d'une valeur comprise entre 1 et 15 MHz. Or, la fréquence d'acquisition $f_C$ des capteurs d'image usuels est typiquement comprise entre quelques dizaines de Hz et quelques dizaines de kHz, par exemple entre 20 Hz et 20 kHz. C'est pour ces raisons que, dans les systèmes du type décrit en relation avec les figures 1 à 3, pour obtenir une fréquence de battement $f_B$ inférieure d'un facteur n à la fréquence d'acquisition $f_C$ du capteur ($f_B = f_C/n$), on prévoit deux modulateurs acousto-optique. En effet, même s'il serait possible d'obtenir des interférences entre le faisceau objet et le faisceau de référence avec un seul modulateur acousto-optique dans le système de la figure 1, ou sans modulateur acousto-optique dans le système de la figure 3, la fréquence de battement de ces interférences serait alors bien trop élevée par rapport à la fréquence d'acquisition du capteur d'images pour pouvoir mettre en oeuvre un fonctionnement du type décrit en relation avec la figure 2.

A titre d'exemple numérique illustratif et non limitatif : dans le système de la figure 1, le capteur 109 peut avoir une fréquence d'acquisition $f_C$ de 8 kHz, et les décalages fréquentiels $f_{MAO1}$ et $f_{MAO2}$ introduits par les modulateurs MAO1 et MAO2 peuvent être respectivement de 79,999 MHz et de 80,001 MHz pour obtenir une fréquence de battement $f_B = f_{MAO2}-f_{MAO1} = 2$ kHz $= f_C/4$ ; et, dans le système de la figure 3, le capteur 109 peut avoir une fréquence d'acquisition $f_C$ de 8 kHz, et les décalages fréquentiels $f_{MAO1}$, $f_{MAO2}$ et $f_{US}$ introduits par les modulateurs MAO1 et MAO2 et par l'onde ultrasonore d'excitation de l'échantillon 305 peuvent être respectivement de 79,999 MHz, 77,001 MHz et 3 MHz, pour obtenir une fréquence de battement $f_B = f_{MAO2} + f_{US} - f_{MAO1} = 2$ kHz $= f_C/4$.

Un autre inconvénient des systèmes d'acquisition d'images par holographie numérique hétérodyne du type décrit en relation avec les figures 1 à 3 est lié aux seuils de saturation des pixels du capteur, qui limitent la puissance lumineuse qui peut être reçue par le capteur. En effet, la puissance lumineuse reçue par chaque pixel du capteur doit être suffisamment faible pour ne pas risquer de saturer le pixel avant la fin d'une période d'intégration $T_B/n$ du pixel, ce qui peut poser problème dans certaines applications.

Un autre inconvénient des systèmes du type décrit en relation avec les figures 1 à 3 est que le rapport signal sur bruit en sortie du système est relativement faible, notamment en raison du fait qu'une part importante des charges photogénérées dans chaque pixel pendant une période d'intégration $T_B/n$ du pixel correspond à la composante continue $a_0$ du signal, qui n'est plus exploitée après la reconstruction du signal objet. A titre d'exemple, dans le système décrit en relation avec les figures 1 et 2, la composante continue $a_0$ de l'intensité I reçue par un pixel du capteur 109 est égale à la somme de l'intensité lumineuse $I_0$ du faisceau objet au niveau de ce pixel et de l'intensité lumineuse $I_R$ du faisceau de référence au niveau de ce pixel, et l'amplitude de crête $a_1$ de l'intensité I reçue par le pixel s'exprime par la formule

$$a_1 = \sqrt{I_R I_O}\cos(\phi_R - \phi_O),$$

$\phi_R$ et $\phi_O$ étant respectivement la phase du faisceau de référence et la phase du faisceau objet. L'amplitude de crête $a_1$ correspond à la partie utile du signal reçu par le capteur, permettant notamment de reconstruire la phase et l'amplitude du faisceau objet. Il est donc souhaitable que la valeur $a_1$ soit la plus élevée possible. Toutefois, si on augmente la puissance lumineuse totale fournie au capteur pour augmenter la valeur de la composante $a_1$, ceci provoque une augmentation au carré de la composante continue $a_0$. Le rapport signal sur bruit n'est donc pas amélioré de façon significative et le seuil de saturation du pixel risque d'être atteint avant la fin d'une période d'intégration $T_B/n$ du pixel.

Un objet des modes de réalisation décrits ci-après est de prévoir un système d'acquisition d'images par holographie numérique hétérodyne permettant de pallier tout ou partie des inconvénients susmentionnés.

Selon un aspect des modes de réalisation décrits, on prévoit un système d'acquisition d'images par holographie numérique hétérodyne, comportant un capteur d'images à sur-échantillonnage, c'est-à-dire un capteur d'images ayant au moins une photodiode couplée à un convertisseur analogique-numérique à sur-échantillonnage, par exemple un convertisseur de type sigma-delta.

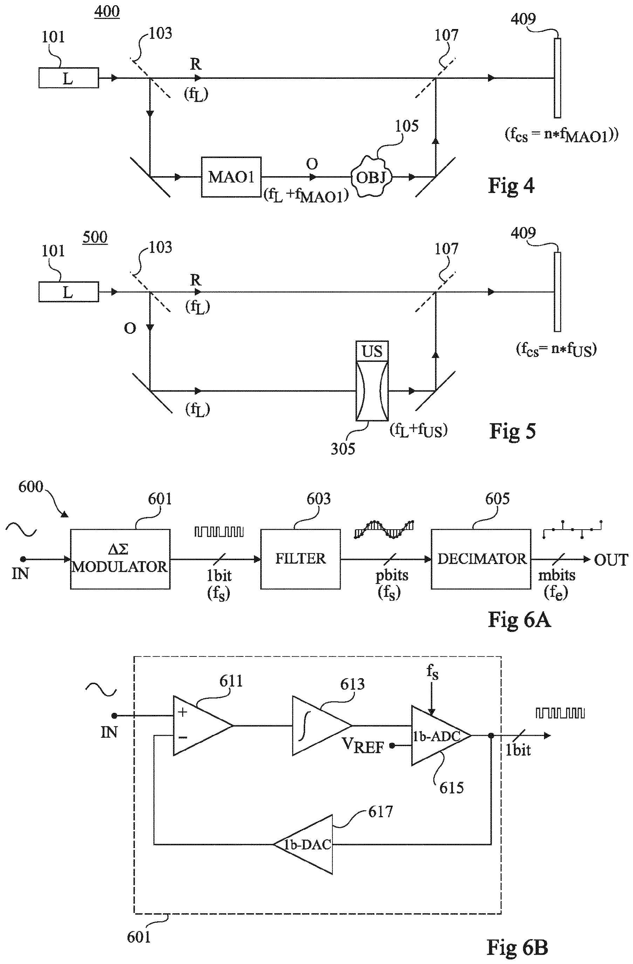

Comme cela sera expliqué plus en détail ci-après, l'utilisation d'un capteur d'images à sur-échantillonnage dans un système d'acquisition d'images par holographie numérique hétérodyne permet de réaliser un système fonctionnant avec une fréquence de battement $f_B = f_{Cs}/n$, où $f_{Cs}$ est la fréquence de sur-échantillonnage du capteur. A titre d'exemple, la fréquence de sur-échantillonnage $f_{Cs}$ peut être comprise entre 1 MHz et 100 MHz. On peut donc réaliser un système fonctionnant avec une fréquence de battement $f_B$ de l'ordre de plusieurs MHz à plusieurs dizaines de MHz. Ceci permet de réaliser un système d'acquisition d'images par holographie numérique hétérodyne particulièrement simple, peu coûteux et peu encombrant. En particulier, ceci permet, comme illustré par les figures 4 et 5, d'économiser un modulateur acousto-optique par rapport à un système du type décrit en relation avec la figure 1, ou deux modulateurs acousto-optiques par rapport à un système décrit en relation avec la figure 3.

La figure 4 représente de façon schématique un exemple d'un mode de réalisation d'un système 400 d'acquisition d'images par holographie numérique hétérodyne. Le système 400 comprend des éléments communs avec le système 100 de la figure 1. Seules les différences entre les systèmes 100 de la figure 1 et 400 de la figure 4 seront détaillées par la suite.

Le système 400 comprend, comme le système 100 de la figure 1, une source lumineuse 101 adaptée à générer un faisceau lumineux cohérent de fréquence $f_L$, et un séparateur 103 adapté à diviser un faisceau fourni par la source 101 en un faisceau objet O et un faisceau de référence R. Dans l'exemple de la figure 4, le faisceau objet O est modulé par un modulateur acousto-optique MAO1 décalant sa fréquence d'une valeur $f_{MAO1}$, par exemple comprise entre 5 et 100 MHz, et le faisceau de référence R n'est pas modulé par un modulateur acousto-optique et reste donc à la fréquence $f_L$. A titre de variante, le modulateur acousto-optique MAO1 peut être agencé pour moduler le faisceau de référence R et pas le faisceau objet O. Le système 400 est agencé de façon que le faisceau objet, de fréquence $f_L+f_{MAO1}$, illumine un objet 105 (OBJ) à examiner ou analyser, le faisceau de référence, de fréquence $f_L$, ne passant pas par l'objet 105. Le faisceau de référence et le faisceau objet réfléchi ou transmis par l'objet 105 sont ensuite dirigés vers un élément de recombinaison 107 qui les recombine. Le faisceau résultant fourni par l'élément 107, comportant à la fois le signal objet et le signal de référence, est projeté sur un capteur d'images 409 à sur-échantillonnage, comportant un ou plusieurs pixels (non visibles sur la figure 4), par exemple une matrice de pixels, chaque pixel comportant une photodiode couplée à un convertisseur analogique-numérique à sur-échantillonnage.

En fonctionnement, le capteur 409 voit une figure d'interférences présentant une fréquence de battement $f_B$ égale à la valeur absolue de la différence de fréquence entre le faisceau objet et le faisceau de référence, c'est-à-dire égale à la valeur $f_{MAO1}$. La fréquence de battement $f_B = f_{MAO1}$ du système est choisie telle que la fréquence de sur-échantillonnage $f_{Cs}$ du capteur 409 soit égale à un nombre n entier de fois la fréquence de battement $f_B$, par exemple $f_{Cs} = 4*f_B$.

La figure 5 représente de façon schématique un exemple d'un mode de réalisation d'un système 500 d'acquisition d'images par holographie numérique hétérodyne. Le système 500 comprend des éléments communs avec le système 300 de la figure 3. Seules les différences entre les systèmes 300 de la figure 3 et 500 de la figure 5 seront détaillées par la suite.

Comme le système 300 de la figure 3, le système 500 comprend une source lumineuse 101 adaptée à générer un faisceau lumineux cohérent de fréquence $f_L$, et un séparateur 103 adapté à diviser un faisceau fourni par la source 101 en un faisceau objet O et un faisceau de référence R. Le système 500 est agencé de façon que le faisceau objet O illumine un objet ou échantillon 305 à analyser, et que le faisceau de référence ne passe pas par l'objet 305. Dans l'exemple de la figure 5, le faisceau de référence n'est pas modulé par un modulateur acousto-optique et reste donc à la fréquence $f_L$, et le faisceau objet n'est pas modulé par un modulateur acousto-optique et reste donc aussi à la fréquence $f_L$ avant d'atteindre l'objet 305. Dans le système 500, une partie de l'objet ou échantillon 305 est excitée par une onde ultrasonore focalisée de fréquence $f_{US}$, par exemple comprise entre 1 et 15 MHz. Il en résulte que la fréquence des rayons du faisceau objet passant par la partie excitée de l'échantillon est décalée à la valeur $f_L+f_{US}$, alors que la fréquence des rayons du faisceau objet passant par les parties non-excitées de l'échantillon reste à la valeur $f_L$. Ce décalage fréquentiel permet, de façon similaire à ce qui a été décrit dans l'exemple de la figure 3, de "marquer" les photons du faisceau objet passés par la partie excitée de l'échantillon par rapport aux autres photons du faisceau objet. Le faisceau de référence et le faisceau objet sont ensuite dirigés vers un élément de recombinaison 107. Le faisceau résultant fourni par l'élément 107, comportant à la fois le signal objet et le signal de référence, est projeté sur un capteur d'images à sur-échantillonnage 409 qui peut être identique ou similaire à celui de la figure 4.

En fonctionnement, le capteur 409 voit une figure d'interférences présentant une fréquence de battement $f_B$ égale à la valeur absolue de la différence de fréquence entre le faisceau de référence et la portion du faisceau objet passée par la partie excitée de l'échantillon 305, c'est-à-dire égale à la valeur $f_{US}$. La fréquence de battement $f_B = f_{US}$ du système 500 est choisie telle que la fréquence de sur-échantillonnage $f_{Cs}$ du capteur 409 soit égale à un nombre n entier de fois la fréquence de battement $f_B$, par exemple $f_{Cs} = 4*f_B$.

Les figures 6A et 6B représentent schématiquement, sous forme de blocs, un exemple de réalisation d'un convertisseur analogique-numérique à sur-échantillonnage 600 de type sigma-delta. La figure 6A est une vue d'ensemble du convertisseur 600, et la figure 6B représente de façon plus détaillée un bloc de modulation du convertisseur 600.

Le convertisseur 600 comprend une entrée IN adaptée à recevoir un signal analogique à numériser, et une sortie OUT adaptée à fournir, à une fréquence d'échantillonnage $f_e$, des échantillons de sortie numérisés sur m-bits, où m est un nombre entier supérieur ou égal à 1.

Le convertisseur 600 comprend un modulateur à sur-échantillonnage 601 ($\Delta\Sigma$ MODULATOR) qui reçoit en entrée le signal analogique appliqué sur l'entrée IN du convertisseur, et fournit en sortie une suite d'échantillons intermédiaires basse résolution, des échantillons de 1-bit dans cet exemple, à une fréquence de sur-échantillonnage $f_s$ plus élevée que la fréquence d'échantillonnage $f_e$, par exemple égale à un multiple de la fréquence d'échantillonnage $f_e$.

Le modulateur 601 est représenté de façon plus détaillée en figure 6B. Il comprend un circuit analogique de soustraction 611 à deux entrées, respectivement positive (+) et négative (-), et une sortie. Ce circuit peut par exemple être constitué par un montage à capacités commutées. L'entrée positive du circuit 611 est reliée à l'entrée IN du convertisseur 600, et la sortie du circuit 611 est reliée à une entrée d'un intégrateur analogique 613, qui peut par exemple comprendre un condensateur en contre-réaction d'un amplificateur. Le modulateur 601 comprend en outre un comparateur 615 cadencé à la fréquence de sur-échantillonnage $f_s$ du convertisseur. Le comparateur 615 a une première entrée reliée à une sortie de l'intégrateur 613, et une deuxième entrée adaptée à recevoir un signal de référence $V_{REF}$. La sortie du comparateur 615 correspond dans cet exemple à la sortie du modulateur 601. En fonctionnement, le comparateur 615 compare, à la fréquence $f_s$, le signal de sortie de l'intégrateur 613 au signal de référence $V_{REF}$, et fournit un signal de sortie numérique sur 1-bit correspondant au résultat de la comparaison. La sortie du comparateur 615 est de plus reliée à l'entrée d'un convertisseur numérique-analogique 1-bit 617, la sortie du convertisseur 617 étant reliée à l'entrée négative du circuit 611.

Le convertisseur 600 comprend en outre un filtre numérique 603 (FILTER) qui reçoit en entrée les échantillons intermédiaires de 1-bit fournis par le modulateur 601, et fournit à sa sortie, à la fréquence de sur-échantillonnage $f_s$, une suite d'échantillons intermédiaires numériques de p-bits par échantillon, où p est un nombre entier supérieur ou égal à m. Le filtre 603 a notamment pour fonction de générer des échantillons haute résolution représentatifs du signal analogique d'entrée à partir des échantillons de 1-bit fournis par le modulateur 601, et de réaliser un filtrage passe-bas permettant de supprimer en grande partie le bruit introduit par le modulateur 601. A titre d'exemple, le filtre 603 comprend un intégrateur numérique d'ordre 1, c'est-à-dire un compteur qui effectue une sommation d'échantillons successifs du signal de sortie du modulateur 601. Dans ce cas particulier, le nombre p de bits des échantillons intermédiaires en sortie du filtre 603 est égal au nombre m de bits des échantillons de sortie du convertisseur 600.

Le convertisseur 600 comprend en outre un circuit de sous-échantillonnage 605 (DECIMATOR) qui reçoit en entrée les échantillons intermédiaires de p-bits fournis par le filtre 603 à la fréquence $f_s$, et fournit en sortie une suite d'échantillons de sortie de m-bits par échantillon, à la fréquence d'échantillonnage $f_e$ ou fréquence de sortie du convertisseur 600. La sortie du circuit de sous-échantillonnage 605 est reliée à la sortie OUT du convertisseur 600.

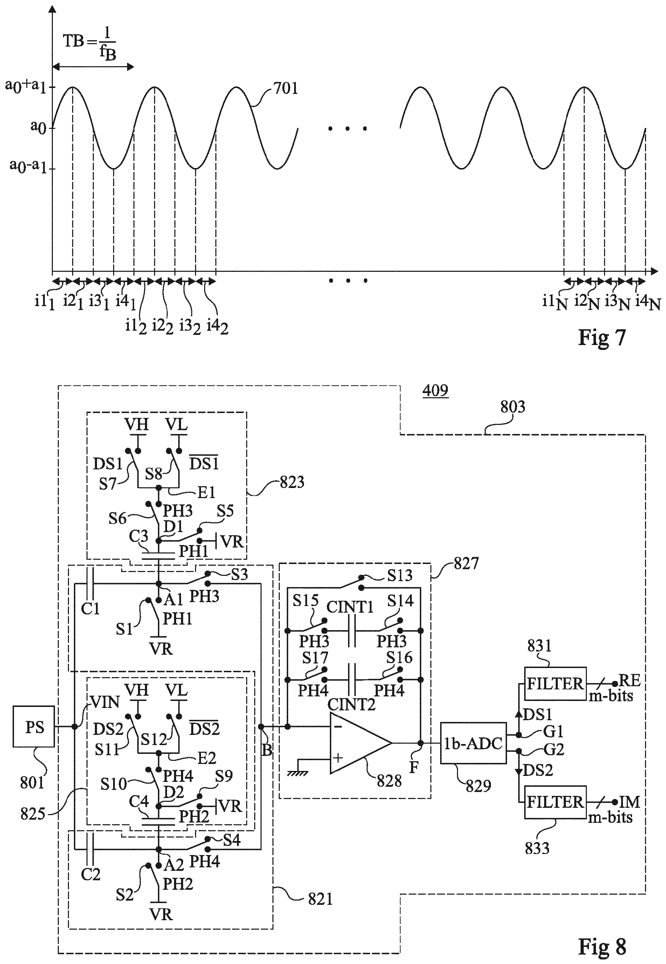

La figure 7 est un diagramme illustrant de façon schématique un exemple de fonctionnement d'un système d'acquisition d'images par holographie numérique hétérodyne comportant un capteur d'images à sur-échantillonnage, par exemple un système du type décrit en relation avec la figure 4 ou 5.

Le diagramme de la figure 7 comprend une courbe 701 représentant l'évolution, en fonction du temps, de l'intensité lumineuse I reçue par un pixel du capteur 409 du système, lorsque le capteur 409 est éclairé par le faisceau fourni par l'élément 107, combinant le faisceau objet et le faisceau de référence. Comme cela apparaît sur la figure, l'intensité I reçue évolue de façon sinusoïdale autour d'une valeur moyenne ou composante continue $a_0$, avec une amplitude de crête de valeur $a_1$, à une fréquence égale à la fréquence de battement $f_B$ du système ($f_B = f_{MAO1}$ dans l'exemple de la figure 4 et $f_B = f_{US}$ dans l'exemple de la figure 5). Les intensités lumineuses reçues par différents pixels du capteur 409 peuvent avoir des composantes continues $a_0$ distinctes et/ou des amplitudes $a_1$ distinctes, mais fluctuent toutes de façon sinusoïdale à la fréquence de battement $f_B$, avec des déphasages propres.

Dans cet exemple, la fréquence de sur-échantillonnage $f_{Cs}$ du capteur d'images 409 est égale à n=4 fois la fréquence de battement $f_B$ du système. A la différence des systèmes des figures 1 à 3 dans lesquels, pour un pixel donné du capteur 109, l'acquisition du champ complexe du faisceau objet au niveau du pixel peut être effectuée en une période de battement $T_B$ du système, dans le mode de réalisation de la figure 7, pour un pixel donné du capteur 409, une acquisition du champ complexe du faisceau objet reçu au niveau du pixel s'effectue en N périodes de battement $T_B$, où N est un nombre entier supérieur à 1.

A chaque période de battement $T_B$ d'une période $N*T_B$ d'acquisition du champ complexe du faisceau objet au niveau du pixel, quatre valeurs analogiques de sortie du pixel $i1_i$, $i2_i$, $i3_i$ et $i4_i$ sont acquises à des instants successifs décalés de $T_B/4$ (c'est-à-dire avec un déphasage de $\pi/2$), où i est un nombre entier allant de 1 à N. On se ramène ainsi, dans cet exemple à l'observation, pendant la période d'acquisition $N*T_B$, de quatre signaux continus i1, i2, i3 et i4 échantillonnés à la fréquence $f_B$. On notera que si le pixel fournit un signal représentatif d'une accumulation de charges photogénérées dans sa photodiode, la photodiode du pixel peut être réinitialisée entre deux acquisitions successives d'une valeur analogique de sortie du pixel. Si en revanche la photodiode du pixel est polarisée à une tension de référence fixe et si le pixel fournit un signal représentatif d'un photo-courant circulant dans la photodiode, le pixel peut ne pas être réinitialisé entre deux acquisitions successives d'une valeur analogique de sortie du pixel. Un convertisseur analogique-numérique à sur-échantillonnage couplé à la photodiode du pixel, par exemple un convertisseur de type sigma-delta, peut fournir, à l'issue de la période d'acquisition $N*T_B$, pour chacun des signaux continus i1, i2, i3 et i4 observés, un échantillon numérique de m bits représentatif du niveau du signal, où m est un nombre entier supérieur à 1, par exemple compris dans la plage allant de 8 à 24. A titre d'exemple, le nombre m de bits des échantillons de sortie peut être égal à $\log_2(N)$ pour un modulateur delta sigma d'ordre 1. Pour chaque pixel du capteur, le champ complexe $E_O$ du faisceau objet reçu par le capteur peut être déterminé par la formule $E_O = (i1-i3) + j(i2-i4)$, la composante $i1-i3$ correspondant à la partie réelle du champ $E_O$, et la composante $i2-i4$ correspondant à la partie imaginaire du champ $E_O$. La phase $P_O$ et l'amplitude $A_O$ du signal objet reçu par chaque pixel du capteur peuvent être déterminées par les formules suivantes :

$$P_O = \arctan\left((i2 - i4)/(i1 - i3)\right),$$

et

$$A_O = \sqrt{(i1 - i3)^2 + (i2 - i4)^2}.$$

On notera que le ratio n entre la fréquence de battement $f_B$ du système et la fréquence de sur-échantillonnage $f_{Cs}$ du capteur d'images peut être un nombre entier différent de 4, par exemple n = 2, n = 3, ou n = 5. Dans ce cas, le principe de fonctionnement est similaire à ce qui a été décrit précédemment, mais les formules de reconstruction du champ complexe du signal objet sont différentes.

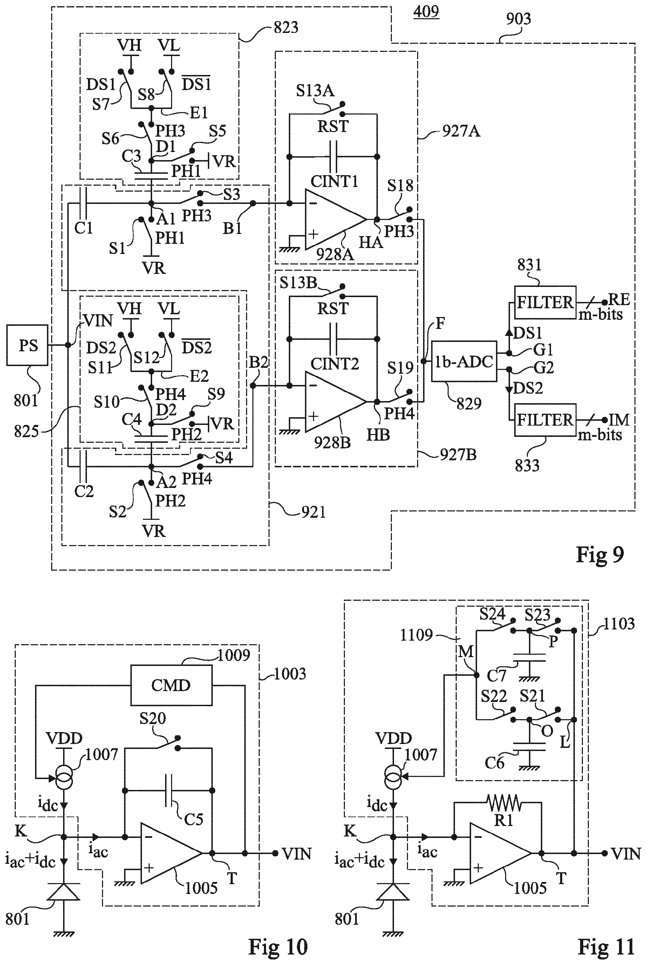

Dans l'exemple susmentionné où n=4, afin de réduire les contraintes sur la gamme dynamique du convertisseur analogique-numérique à sur-échantillonnage, les opérations de soustraction i1-i3 et i2-i4 peuvent être effectuées avant la fourniture des échantillons numérisés sur m bits, par exemple au moment de l'acquisition des valeurs analogiques $i1_i$, $i2_i$, $i3_i$ et $i4_i$ comme cela sera expliqué plus en détail en relation avec les exemples de capteur des figures 8 et 9. Dans ce cas, on se ramène à l'observation, pendant la période d'acquisition de durée $N^*T_B$, de deux signaux continus i1-i3 et i2-i4, chacun des deux signaux étant échantillonnés à la fréquence $f_B$. Le convertisseur analogique-numérique à sur-échantillonnage couplé à la photodiode permet alors de fournir, à l'issue de la période d'acquisition $N^*T_B$, pour chacun des deux signaux continus i1-i3 et i2-i4 observés, un échantillon numérique de m bits représentatif du niveau du signal. Un avantage est que la composante continue $a_0$ du signal reçu par chaque pixel du capteur est éliminée avant la phase de numérisation proprement dite par le convertisseur analogique numérique, ce qui réduit les contraintes sur la dynamique du convertisseur. Les modes de réalisation décrits ne se limitent toutefois pas à cette solution particulière. A titre de variante, les différences i1-i3 et i2-i4 peuvent être calculées sur des échantillons numériques de 1-bit, au sein d'un ou plusieurs compteurs d'un filtre numérique du convertisseur à sur-échantillonnage.

La figure 8 représente de façon schématique et partielle un exemple non limitatif de réalisation du capteur d'images 409 des systèmes d'acquisition d'images des figures 4 et 5, dans le cas n = 4.

Sur la figure 8, seul un pixel 801 du capteur 409 a été représenté. Le pixel 801 peut comprendre une photodiode (non représentée) et un ou plusieurs transistors de commande (non représentés). En pratique, le capteur 409 peut comporter une pluralité de pixels identiques ou similaires au pixel 801, par exemple disposés en matrice. Le capteur 409 comprend en outre, couplé au pixel 801, un circuit 803 de conversion analogique-numérique à sur-échantillonnage. Dans cet exemple, le circuit 803 a un noeud d'entrée analogique VIN relié à un noeud de fourniture d'un signal de sortie du pixel 801, et deux sorties numériques RE et IM de m bits chacune, adaptées à fournir des signaux numériques représentatifs respectivement de la partie réelle et de la partie imaginaire du champ complexe du faisceau objet au niveau du pixel 801. En pratique, le capteur 409 peut comporter plusieurs circuits de conversion analogique-numérique à sur-échantillonnage similaires ou identiques au circuit 803. A titre d'exemple, le capteur 409 peut comporter un circuit de conversion analogique-numérique par pixel du capteur. Alternativement, pour réduire la surface totale du capteur, un circuit de conversion analogique-numérique peut être partagé par plusieurs pixels du capteur au moyen de multiplexeurs.

Le circuit 803 comprend un bloc analogique d'échantillonnage 821, adapté à acquérir dans un ou plusieurs condensateurs des échantillons analogiques du signal de sortie du pixel 801 à la fréquence de sur-échantillonnage $f_{Cs}$ du capteur, soit quatre échantillons $i1_i$, $i2_i$, $i3_i$ et $i4_i$ par période de battement $T_B$ du système dans cet exemple. Le bloc 821 est en outre adapté à effectuer en analogique, à chaque période de battement $T_B$ de la période d'acquisition $N^*T_B$, des opérations arithmétiques sur les échantillons analogiques acquis. Plus particulièrement, dans cet exemple, le bloc 821 est adapté à calculer en analogique, à chaque période de battement $T_B$, les différences $i1_i$-$i3_i$ et $i2_i$-$i4_i$.

Dans l'exemple de la figure 8, le bloc 821 comprend un condensateur C1 reliant le noeud VIN à un noeud A1, un condensateur C2 reliant le noeud VIN à un noeud A2, un interrupteur S1 reliant le noeud A1 à un noeud d'application d'un premier potentiel de référence VR, un interrupteur S2 reliant le noeud A2 au noeud VR, un interrupteur S3 reliant le noeud A1 au noeud B de sortie du bloc 821, et un interrupteur S4 reliant le noeud A2 au noeud B.

Le circuit 803 comprend en outre un premier circuit ou bloc 823 de conversion analogique-numérique, adapté à convertir en analogique un signal numérique d'entrée DS1 de 1-bit par échantillon et à soustraire le signal analogique résultant au signal analogique $i1_i$-$i3_i$ calculé par le bloc 821, et un deuxième circuit ou bloc 825 de conversion analogique-numérique, adapté à convertir en analogique un signal numérique d'entrée DS2 de 1-bit par échantillon et à soustraire le signal analogique résultant au signal analogique $i2_i$-$i4_i$ calculé par le bloc 821.

Dans l'exemple de la figure 8, le bloc 823 comprend un condensateur C3 reliant le noeud A1 à un noeud D1, un interrupteur S5 reliant le noeud D1 au noeud VR, un interrupteur S6 reliant le noeud D1 à un noeud E1, un interrupteur S7 reliant le noeud E1 à un noeud d'application d'un deuxième potentiel de référence VH, par exemple supérieur au potentiel VR, et un interrupteur S8 reliant le noeud E1 à un noeud d'application d'un troisième potentiel de référence VL inférieur au potentiel VH, par exemple inférieur au potentiel VR. L'interrupteur S7 a un noeud de commande recevant le signal numérique DS1 à convertir, et l'interrupteur S8 a un noeud de commande recevant le complémentaire du signal DS1. De plus, dans l'exemple de la figure 8, le bloc 825 comprend un condensateur C4 reliant le noeud A2 à un noeud D2, un interrupteur S9 reliant le noeud D2 au noeud VR, un interrupteur S10 reliant le noeud D2 à un noeud E2, un interrupteur S11 reliant le noeud E2 au noeud VH, et un interrupteur S12 reliant le noeud E2 au noeud VL. L'interrupteur S11 a un noeud de commande recevant le signal numérique DS2 à convertir, et l'interrupteur S12 a un noeud de commande recevant le complémentaire du signal DS2.

Le circuit 803 comprend en outre un intégrateur 827 adapté à intégrer séparément les composantes i1-i3 et i2-i4 du signal de sortie du pixel 801.

Dans l'exemple de la figure 8, l'intégrateur 827 comporte un amplificateur différentiel 828 dont une entrée positive (+) est reliée à un noeud d'application d'un potentiel de référence, par exemple la masse, et dont une entrée négative (-) est reliée au noeud B. L'amplificateur différentiel 828 comporte en outre une sortie F couplée au noeud B par trois branches parallèles : une première branche comportant un interrupteur de réinitialisation S13 reliant le noeud F au noeud B ; une deuxième branche comportant, en série entre le noeud F et le noeud B, un interrupteur S14, un premier condensateur d'intégration CINT1 et un interrupteur S15; et une troisième branche comportant, en série entre le noeud F et le noeud B, un interrupteur S16, un deuxième condensateur d'intégration CINT2 et un interrupteur S17.

Le circuit 803 comprend en outre un convertisseur analogique-numérique 1-bit 829 comportant une entrée analogique reliée au noeud F de sortie de l'intégrateur 827. Dans l'exemple de la figure 8, le convertisseur 829 comporte deux sorties numériques G1 et G2 de 1-bit chacune. Le convertisseur 829 est adapté à fournir sur sa sortie G1, à la fréquence $f_{CS}/4$, une suite d'échantillons de 1-bit représentative de la différence i1-i3, formant le signal DS1, et, sur sa sortie G2, à la fréquence $f_{CS}/4$, une suite d'échantillons de 1-bit représentative de la différence i2-i4, formant le signal DS2. La sortie G1 du convertisseur 829 peut être directement reliée au noeud de commande de l'interrupteur S7, et être reliée au noeud de commande de l'interrupteur S8 par l'intermédiaire d'un inverseur. La sortie G2 du convertisseur 829 peut être directement reliée au noeud de commande de l'interrupteur S11, et être reliée au noeud de commande de l'interrupteur S12 par l'intermédiaire d'un inverseur.

Le convertisseur 829 peut par exemple comprendre un comparateur (non représenté) dont une entrée est reliée au noeud F, et dont une sortie, fournissant un signal binaire représentatif du résultat de la comparaison du signal d'entrée à un seuil, est reliée à la sortie G1 du convertisseur par l'intermédiaire d'une première bascule ou cellule à retard (non représentée), et à la sortie G2 du convertisseur par l'intermédiaire d'une deuxième bascule ou cellule à retard (non représentée).

Le circuit 803 comprend en outre un premier circuit 831 de filtrage numérique (FILTER) qui reçoit en entrée les échantillons intermédiaires de 1-bit fournis par le convertisseur 829 sur sa sortie G1. Le circuit 831 est adapté à fournir, à l'issue d'une période d'acquisition $N^*T_B$, sur une sortie de m bits reliée à la sortie RE du circuit 803, un échantillon numérique de m bits représentatif de la différence i1-i3. Le circuit 803 comprend en outre un second circuit 833 de filtrage numérique (FILTER) qui reçoit en entrée les échantillons intermédiaires de 1-bit fournis par le convertisseur 829 sur sa sortie G2. Le circuit 833 est adapté à fournir, à l'issue d'une période d'acquisition $N^*T_B$, sur une sortie de m bits reliée à la sortie IM du circuit 803, un échantillon numérique représentatif de la différence i2-i4. A titre d'exemple, chacun des circuits 831 et 833 comprend un compteur qui additionne les valeurs de N échantillons successifs des signaux DS1 et DS2 respectivement, le circuit 831 fournissant sur la sortie RE le résultat de la somme des N échantillons successifs du signal DS1, et le circuit 833 fournissant sur la sortie IM le résultat de la somme des N échantillons successifs du signal DS2. Dans ce cas, le nombre m de bits des échantillons de sortie est égal à $\log_2(N)$.

Un exemple de fonctionnement du circuit 803 de la figure 8 va maintenant être décrit. Pendant une période d'acquisition $N^*T_B$ du champ complexe du faisceau objet au niveau du pixel, à chaque période de battement $T_B$ du système, les interrupteurs S1 à S6, S9, S10 et S13 à S17 sont commandés comme suit :

    initialement, les interrupteurs S13, S14, S15, S16 et S17 sont fermés (passants) et les autres interrupteurs sont ouverts (non passants) ;

    pendant une première période d'acquisition PH1 correspondant sensiblement au premier quart de la période $T_B$, les interrupteurs S1 et S5 sont fermés (passants), et les interrupteurs S2 à S4, S6, S9, S10 et S13 à S17 sont ouverts (non passants) ;

    pendant une deuxième période d'acquisition PH2 correspondant sensiblement au deuxième quart de la période $T_B$, les interrupteurs S2 et S9 sont fermés, et les interrupteurs S1, S3 à S6, S9, S10 et S13 à S17 sont ouverts ;

    pendant une troisième période d'acquisition PH3 correspondant sensiblement au troisième quart de la période $T_B$, les interrupteurs S3, S6, S14 et S15 sont fermés, et les interrupteurs S1, S2, S4, S5, S9, S10, S13, S16 et S17 sont ouverts ; et

    pendant une quatrième période d'acquisition PH4 correspondant sensiblement au quatrième quart de la période $T_B$, les interrupteurs S4, S10, S16 et S17 sont fermés, et les interrupteurs S1 à S3, S5, S6, S9, et S13 à S15 sont ouverts.

Ainsi, pendant chaque période PH3, le résultat analogique de la différence $i1_i$-$i3_i$, auquel est soustraite la valeur analogique du signal de contre-réaction piloté par le signal DS1, est intégré dans le condensateur CINT1, et le résultat de l'intégration est appliqué en entrée du circuit de conversion analogique 1-bit 829. De plus, pendant chaque période PH4, le résultat analogique de la différence $i2_i$-$i4_i$, auquel est soustraite la valeur analogique du signal de contre-réaction piloté par le signal DS2, est intégré dans le condensateur CINT2, et le résultat de l'intégration est appliqué en entrée du circuit de conversion analogique 1-bit 829.

Dans cet exemple, le circuit 829 commandé pour acquérir et fournir sur sa sortie G1, à chaque période PH3, un échantillon correspondant à la numérisation sur 1-bit de la sortie F de l'intégrateur 827, et pour acquérir et fournir sur sa sortie G2, à chaque période PH4, un échantillon correspondant à la numérisation sur 1-bit de la sortie F de l'intégrateur.

Après une période $N*T_B$ d'acquisition du champ complexe du faisceau objet au niveau du pixel 801, le circuit 803 peut être réinitialisé par fermeture des interrupteurs S13, S14, S15, S16 et S17.

La figure 9 représente de façon schématique et partielle une variante de réalisation du capteur d'images 409 de la figure 8. Le capteur de la figure 9 comprend de nombreux éléments communs avec le capteur de la figure 8. Dans la suite, seules les différences entre les capteurs des figures 8 et 9 seront détaillées.

Sur la figure 9, seul un pixel 801 du capteur 409 a été représenté. En pratique, le capteur 409 peut comporter une pluralité de pixels identiques ou similaires au pixel 801, par exemple disposés en matrice. Le capteur 409 comprend en outre, couplé au pixel 801, un circuit 903 de conversion analogique-numérique à sur-échantillonnage. Dans cet exemple, le circuit 903 a un noeud d'entrée analogique VIN relié à un noeud de fourniture d'un signal de sortie du pixel 801, et deux sorties numériques RE et IM de mbits chacune (avec $m = \log_2(N)$ dans le cas d'un convertisseur d'ordre 1), adaptées à fournir des signaux numériques représentatifs respectivement de la partie réelle et de la partie imaginaire du champ complexe du faisceau objet au niveau du pixel 801. En pratique, le capteur 409 peut comporter plusieurs circuits de conversion analogique-numérique à sur-échantillonnage similaires ou identiques au circuit 903. A titre d'exemple, le capteur 409 peut comporter un circuit de conversion analogique-numérique par pixel du capteur. Alternativement, pour réduire la surface totale du capteur, un circuit de conversion analogique-numérique peut être partagé par plusieurs pixels du capteur au moyen de multiplexeurs.

Le circuit 903 comprend des éléments communs avec le circuit 803 de la figure 8. Seules les différences entre ces deux circuits seront détaillées ci-après.

Le circuit 903 comprend un circuit ou bloc analogique d'échantillonnage 921 similaire au bloc 821 de la figure 8. Le bloc 921 de la figure 9 diffère du bloc 821 de la figure 8 seulement par le fait qu'il comprend non pas un unique noeud de sortie B relié au noeud A1 par l'interrupteur S3 d'une part, et au noeud A2 par l'interrupteur S4 d'autre part, mais deux noeuds de sortie B1 et B2 distincts reliés respectivement au noeud A1 par l'interrupteur S3, et au noeud A2 par l'interrupteur S4.

Une autre différence entre le circuit 903 de la figure 9 et le circuit 803 de la figure 8 est que le circuit 903 ne comprend pas, comme dans le circuit 803, un intégrateur 827 à double capacité d'intégration, mais comprend à la place deux intégrateurs 927A et 927B à simple capacité d'intégration. L'intégrateur 927A est adapté à intégrer la composante i1-i3 du signal de sortie du pixel 801, et l'intégrateur 927B est adapté à intégrer la composante i2-i4 du signal de sortie du pixel 801.

Dans l'exemple de la figure 9, l'intégrateur 927A comporte un amplificateur différentiel 928A dont une entrée positive (+) est reliée à un noeud d'application d'un potentiel de référence, par exemple la masse, et dont une entrée négative (-) est reliée au noeud B1, et l'intégrateur 927B comporte un amplificateur différentiel 928B dont une entrée positive (+) est reliée à un noeud d'application d'un potentiel de référence, par exemple la masse, et dont une entrée négative (-) est reliée au noeud B2. L'amplificateur différentiel 928A comporte une sortie HA couplée au noeud B1 par deux branches parallèles : une première branche comportant un interrupteur de réinitialisation S13A ; et une deuxième branche comportant un condensateur d'intégration CINT1. De plus, l'amplificateur différentiel 928B comporte une sortie HB couplée au noeud B2 par deux branches parallèles : une première branche comportant un interrupteur de réinitialisation S13B ; et une deuxième branche comportant un condensateur d'intégration CINT2. Dans l'exemple de la figure 9, le noeud HA est relié au noeud F d'entrée du convertisseur analogique-numérique 1-bit 829 par un interrupteur S18, et le noeud HB est relié au noeud F par un interrupteur S19.

Le fonctionnement du circuit 903 de la figure 9 est similaire à celui du circuit 803 de la figure 8. En particulier, les interrupteurs S1 à S6, S9 et S10 du circuit 903 peuvent être commandés de la même façon que dans le circuit 803 de la figure 8. Dans le circuit 903, l'interrupteur S18 peut être ouvert pendant les phases de fonctionnement PH1, PH2 et PH4 et fermé pendant les phases de fonctionnement PH3, et l'interrupteur S19 peut être ouvert pendant les phases de fonctionnement PH1, PH2 et PH3 et fermé pendant les phases de fonctionnement PH4. Après une période $N*T_B$ d'acquisition du champ complexe du faisceau objet au niveau du pixel 801, le circuit 903 peut être réinitialisé par fermeture des interrupteurs S13A et S13B (les autres interrupteurs étant ouverts).

Un avantage du capteur de la figure 9 par rapport au capteur de la figure 8 est qu'il permet de limiter des risques d'erreur liés à d'éventuels phénomènes d'interférence ou diaphonie (en anglais "crosstalk") entre les condensateurs d'intégration CINT1 et CINT2.

On notera que dans un capteur d'images à sur-échantillonnage d'un système d'acquisition d'images par holographie numérique hétérodyne, par exemple un capteur du type décrit en relation avec les figures 8 et 9, notamment lorsque la composante continue $a_0$ (figure 7) du signal reçu par un pixel du capteur est importante devant la composante alternative $a_1$, il peut être avantageux de filtrer la composante $a_0$ avant l'échantillonnage analogique du signal par le modulateur à sur-échantillonnage (formé par les blocs 821, 823, 825, 827 et 829 dans l'exemple de la figure 8 et par les blocs 921, 823, 825, 927A, 927B et 829 dans l'exemple de la figure 9). Des exemples de circuits adaptés à réaliser cette fonction de filtrage passe-haut vont maintenant être décrits en relation avec les figures 10, 11 et 12.

La figure 10 représente de façon schématique et partielle un exemple de réalisation d'un capteur d'images comportant au moins un pixel 801 et un circuit 1003 de filtrage passe-haut d'un signal de sortie de ce pixel. A titre d'exemple, dans un capteur à sur-échantillonnage, le circuit de filtrage 1003 peut être placé entre la sortie du pixel 801 et l'entrée VIN du modulateur à sur-échantillonnage du capteur.

Dans l'exemple de la figure 10, le pixel 801 comporte une photodiode polarisée en inverse par une tension de référence VDD constante, et fournissant sur sa cathode K un courant représentatif de l'intensité lumineuse reçue par le pixel. Le pixel 801 peut en outre comporter divers éléments de commande non représentés. Dans une application à un système d'acquisition d'images par holographie numérique hétérodyne du type décrit ci-avant, le courant fourni par la photodiode comporte une composante continue $i_{dc}$ qui correspond à la composante continue $a_0$ du signal lumineux reçu par le pixel, et une composante alternative $i_{ac}$ qui correspond à la composante alternative $a_1$ du signal lumineux reçu par le pixel.

Le filtre 1003 comprend un amplificateur différentiel 1005 dont une entrée positive (+) est reliée à un noeud d'application d'un potentiel de référence, par exemple à la masse, et dont une entrée négative (-) est reliée à la cathode K de la photodiode. L'amplificateur différentiel 1005 comporte en outre un noeud de sortie T qui peut être relié au noeud VIN. Le noeud T est couplé au noeud K par deux branches parallèles : une première branche comportant un interrupteur de réinitialisation S20 ; et une deuxième branche comportant un condensateur d'intégration C5. Le filtre 1003 comprend en outre une source de courant commandable 1007 reliant le noeud K à un noeud d'application de la tension VDD de polarisation de la photodiode. Le filtre 1003 comprend de plus un circuit analogique 1009 de commande (CMD) de la source 1007, dont une entrée est reliée au noeud T et dont une sortie est reliée à un noeud de commande de la source 1007.

En fonctionnement, le condensateur C5 se charge à une valeur représentative de la valeur moyenne du courant reçu sur l'entrée négative de l'amplificateur différentiel 1005, qui est lui-même égal à la différence entre le courant délivré par la photodiode et le courant délivré par la source 1007. Le circuit de commande 1009 contrôle la source de courant 1007 pour qu'elle délivre un courant continu représentatif de la moyenne du signal de sortie de l'amplificateur 1005. Le signal de sortie fourni sur le noeud T converge vers une tension alternative centrée sur une valeur moyenne constante. Cette tension alternative est représentative de la seule composante alternative du signal lumineux reçu par le pixel. Le filtre 1003 peut être réinitialisé par fermeture de l'interrupteur S20.

La figure 11 représente de façon schématique et partielle un autre exemple de réalisation d'un capteur d'images comportant au moins un pixel 801 et un circuit 1103 de filtrage passe-haut d'un signal de sortie de ce pixel. A titre d'exemple, dans un capteur à sur-échantillonnage, le circuit de filtrage 1103 peut être placé entre la sortie du pixel 801 et l'entrée VIN du modulateur à sur-échantillonnage du capteur.

Dans l'exemple de la figure 11, le pixel 801 est identique ou similaire au pixel 801 de la figure 10.

Le filtre 1103 comprend, comme dans l'exemple de la figure 10, un amplificateur différentiel 1005 dont l'entrée positive (+) est reliée à un noeud d'application d'un potentiel de référence, par exemple à la masse, et dont l'entrée négative (-) est reliée à la cathode K de la photodiode. Le noeud T de sortie de l'amplificateur 1005 peut être relié au noeud VIN d'entrée d'un modulateur à sur-échantillonnage. Dans cet exemple, le noeud T est relié au noeud K par une résistance R1 ou une capacité (non représentée). Le filtre 1103 comprend en outre une source de courant commandable 1007 reliant le noeud K à un noeud d'application de la tension VDD de polarisation de la photodiode. Le filtre 1103 comprend de plus un circuit 1109 de commande de la source de courant 1007, ce circuit comportant un noeud d'entrée L relié au noeud T et un noeud de sortie M relié à un noeud de commande de la source de courant 1007. Le circuit de commande 1109 comprend un condensateur C6 reliant un noeud O à un noeud d'application d'un potentiel de référence, par exemple à la masse, et un condensateur C7 reliant un noeud P à un noeud d'application d'un potentiel de référence, par exemple à la masse. Le circuit 1109 comprend en outre un interrupteur S21 reliant le noeud L au noeud O, un interrupteur S22 reliant le noeud O au noeud M, un interrupteur S23 reliant le noeud L au noeud P, et un interrupteur S24 reliant le noeud P au noeud M.

En fonctionnement, à chaque période de battement $T_B$ du signal lumineux reçu par le pixel 801, le niveau du signal de sortie de l'amplificateur 1005 peut être échantillonné dans les condensateurs C6 et C7 à deux instants distincts déphasés de Pi. Pour cela, l'interrupteur S21 est fermé et les interrupteurs S22, S23 et S24 sont ouverts à un premier instant t0, puis l'interrupteur S23 est fermé et les interrupteurs S21, S22 et S24 sont ouverts à un deuxième instant $t1=t0+T_B/2$. Après l'instant t1, les interrupteurs S24 et S22 peuvent être fermés, ce qui revient à appliquer sur le noeud M un signal représentatif de la moyenne du signal de sortie de l'amplificateur 1005. Le signal de sortie fourni sur le noeud T converge vers une tension alternative centrée sur une valeur moyenne constante. Cette tension alternative est représentative de la seule composante alternative du signal lumineux reçu par le pixel.

Un avantage du circuit de filtrage passe-haut de la figure 11 est qu'il permet une amplification efficace de la partie alternative $i_{ac}$ du signal de sortie de la photodiode. De plus, le fonctionnement du circuit 1103 ne comprend pas de phase de réinitialisation.

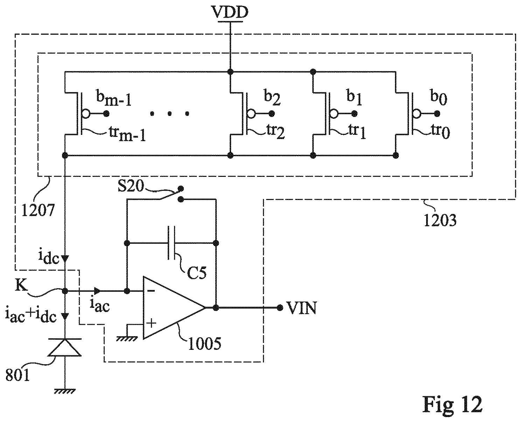

La figure 12 représente de façon schématique et partielle un autre exemple de réalisation d'un capteur d'images comportant au moins un pixel 801 et un circuit 1203 de filtrage passe-haut d'un signal de sortie de ce pixel. A titre d'exemple, dans un capteur à sur-échantillonnage, le circuit de filtrage 1203 peut être placé entre la sortie du pixel 801 et l'entrée VIN du modulateur à sur-échantillonnage du capteur.

Dans l'exemple de la figure 12, le pixel 801 est identique ou similaire au pixel 801 des figures 11 et 12. Le filtre 1203 comprend, comme dans l'exemple de la figure 10, un amplificateur différentiel 1005 dont l'entrée positive (+) est reliée à un noeud d'application d'un potentiel de référence, par exemple à la masse, et dont l'entrée négative (-) est reliée à la cathode K de la photodiode. Le noeud de sortie T de l'amplificateur 1005 peut être relié au noeud VIN d'entrée d'un modulateur à sur-échantillonnage. Le noeud T est en outre couplé au noeud K par deux branches parallèles : une première branche comportant un interrupteur de réinitialisation S20 ; et une deuxième branche comportant un condensateur d'intégration C5. Dans cet exemple, le filtre 1203 comprend en outre une source de courant commandable 1207 reliant le noeud K à un noeud d'application de la tension VDD de polarisation de la photodiode.

Une différence entre le filtre 1203 de la figure 12 et le filtre 1003 de la figure 10 est que, dans le filtre 1203, la source de courant 1207 est une source à commande numérique. Dans le cas d'un capteur d'images à sur-échantillonnage, par exemple un capteur du type décrit en relation avec les figures 8 et 9, la source de courant 1207 peut être commandée par un signal numérique correspondant à un signal de sortie du convertisseur analogique-numérique à sur-échantillonnage. On peut par exemple prévoir avant la phase d'acquisition du champ complexe du faisceau objet au niveau du pixel 801, une phase d'acquisition d'un signal de commande de la source de courant 1207. Un avantage de cet exemple de réalisation est qu'il permet de réutiliser le matériel du capteur à sur-échantillonnage et notamment le convertisseur à sur-échantillonnage pour générer un signal de commande de la source de courant via une recherche dichotomique de la valeur moyenne du signal.

Dans l'exemple représenté, la source de courant 1207 comprend m transistors MOS à canal P $tr_0$, $tr_1$, $tr_2$, ..., $tr_{m-1}$ en parallèle entre le noeud VDD et le noeud K, chaque transistor recevant sur sa grille de commande, respectivement $b_0$, $b_1$, $b_2$, ..., $b_{m-1}$, un bit du signal de commande. Dans cet exemple les transistors $tr_0$, $tr_1$, $tr_2$, ..., $tr_{m-1}$ sont de dimensions distinctes, ce qui permet de tenir compte du poids des différents bits du mot de commande de la source 1207. A titre d'exemple non limitatif, si le transistor $tr_0$ a une largeur de canal W et une longueur de canal L, le transistor $tr_1$ peut avoir un rapport largeur/longueur égal à 2*W/L, le transistor $tr_2$ peut avoir un rapport largeur/longueur égal à 4*W/L, et ainsi de suite jusqu'au transistor $tr_{m-1}$ qui peut avoir un rapport largeur/longueur égal à $2^{m-1}$*W/L.

Outre les avantages déjà mentionnés de simplification et de réduction de coût et d'encombrement, un avantage des modes de réalisation décrits dans la présente demande est qu'ils permettent de réaliser des systèmes d'acquisition d'images par holographie numérique hétérodyne dans lesquels les contraintes liées aux risques de saturation des pixels du capteur sont très atténuées par rapport aux systèmes existants. En effet, dans les modes de réalisation décrits, la fréquence de réinitialisation des photodiodes peut être nettement plus élevée que dans les systèmes existants, ce qui permet notamment de pouvoir utiliser des intensités lumineuses plus élevées pour éclairer l'objet à examiner ou analyser.

Un autre avantage des modes de réalisation décrits est qu'ils permettent de réaliser des systèmes d'acquisition d'images par holographie numérique hétérodyne présentant, en sortie du système d'acquisition, un meilleur rapport signal sur bruit que les systèmes existants. Cette amélioration du rapport signal sur bruit est notamment liée au fait que l'utilisation d'un convertisseur analogique-numérique permet de réduire le bruit du système de quantification par rapport aux systèmes existants. L'amélioration du rapport signal sur bruit peut en outre être amplifiée par l'utilisation d'un circuit de filtrage passe-haut du type décrit en relation avec les figures 10 à 12. La suppression du signal continu avant conversion du signal résiduel alternatif permet en particulier de focaliser les ressources de quantification sur la seule composante alternative, ce qui permet notamment de réduire le facteur de sur-échantillonnage nécessaire à l'obtention d'un signal de sortie utile quantifié sur un nombre donné de bits. De plus, l'erreur résiduelle de cette phase de filtrage de la composante continue est supprimée par l'intégration de la différence de deux échantillons au niveau de l'intégrateur du modulateur delta sigma.

On notera que, dans les systèmes d'acquisition d'images par holographie numérique hétérodyne du type décrit en relation avec la figure 3, utilisant un émetteur d'une onde ultrasonore focalisée pour exciter une portion de l'échantillon à analyser, des méthodes ont déjà été proposées pour améliorer la résolution axiale du système, c'est-à-dire la résolution dans l'axe de propagation de l'onde ultrasonore. Des exemples de telles méthodes sont notamment décrits dans l'article susmentionné de Emilie Benoit a la Guillaume et al., dans l'article intitulé "Theoretical study of acousto-optical coherence tomography using random phase jumps on US and light" de M. Lesaffre et al., et dans l'article intitulé "Acousto-optical coherence tomography using random phase jumps on ultrasound and light" de M. Lesaffre et al..

Selon une première méthode d'amélioration de la résolution axiale dans un système du type décrit en relation avec la figure 3, on prévoit d'émettre l'onde ultrasonore d'excitation par impulsions ou créneaux temporels de durée $\Delta t$. Le modulateur acousto-optique MAO1 de la voie de référence est alors aussi activé de manière impulsionnelle, pendant des créneaux de durée $\Delta t$, décalés d'une durée $\tau$ par rapport aux créneaux d'émission de l'onde ultrasonore. La portion d'échantillon analysable par le système est alors celle excitée par l'impulsion ultrasonore pendant les créneaux où le modulateur acousto-optique MAO1 de la voie de référence est actif. Ainsi, la résolution axiale du système est approximativement égale à $\Delta t * V_{US}$, où $V_{US}$ est la vitesse de propagation de l'onde ultrasonore dans l'échantillon analysé, et la distance entre l'émetteur ultrasonore et la portion de l'échantillon visible par le système est approximativement égale à $\tau * V_{US}$.

Cette première méthode peut être adaptée à un système du type décrit en relation avec la figure 5, dans lequel le capteur d'images est un capteur à sur-échantillonnage, et dans lequel la voie de référence ne comporte pas de modulateur acousto-optique. L'onde ultrasonore focalisée d'excitation de l'échantillon est alors, comme dans les méthodes connues, émise par impulsions ou créneaux temporels de durée $\Delta t$. Toutefois, dans un tel système, les créneaux temporels déphasés de la durée $\tau$ fixant la distance entre l'émetteur ultrasonore et la portion d'échantillon effectivement analysée, ne peuvent pas être appliqués aisément sur la voie de référence, cette dernière ne comportant pas de modulateur acousto-optique. Ainsi, on prévoit d'appliquer ces créneaux temporels sur le convertisseur à sur-échantillonnage lui-même, par l'intermédiaire d'une commande numérique. Plus particulièrement, le modulateur du convertisseur à sur-échantillonnage comprend un noeud d'application d'un signal d'activation binaire BURST_ON, définissant les créneaux temporels de sélection de la portion d'échantillon analysée. Pendant un créneau d'activation du signal BURST_ON, de durée $\Delta t$, le modulateur est actif, et acquiert et traite des échantillons analogiques du signal d'entrée de façon identique ou similaire à ce qui a été décrit ci-avant. En dehors des créneaux d'activation du signal BURST_ON, le modulateur est inhibé et cesse d'acquérir des échantillons du signal d'entrée. L'effet est alors le même que si les créneaux étaient appliqués sur la voie de référence. Les créneaux d'activation du signal BURSTON sont de préférence synchrones avec les phases de fonctionnement du modulateur sigma-delta. En particulier, leur durée $\Delta t$ est de préférence égale à un multiple de la période de sur-échantillonnage du convertisseur.

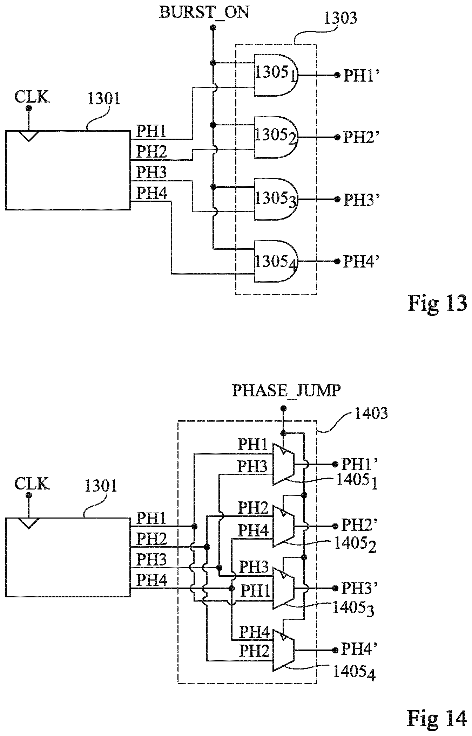

La figure 13 est un schéma simplifié d'un circuit de commande d'un convertisseur analogique-numérique à sur-échantillonnage d'un capteur du type décrit en relation avec les figures 8 ou 9, adapté à recevoir le signal d'activation BURST_ON, et à commander l'acquisition d'échantillons du signal d'entrée uniquement lorsque le signal BURST_ON est à l'état actif (état haut dans cet exemple).

Le circuit de la figure 13 comprend un circuit 1301, cadencé par un signal d'horloge CLK, adapté à générer les signaux PH1, PH2, PH3 et PH4 de commande des interrupteurs d'un convertisseur à sur-échantillonnage du type décrit en relation avec la figure 8 ou 9 (étant entendu que dans les exemples des figures 8 et 9, le signal PH1 est le signal de commande des interrupteurs S1 et S5, le signal PH2 est le signal de commande des interrupteurs S2 et S9, le signal PH3 est le signal de commande des interrupteurs S3, S6, S14, S15 et S18, et le signal PH4 est le signal de commande des interrupteurs S4, S10, S16, S17 et S19).

Le circuit de la figure 13 comprend en outre un circuit d'activation 1303 comportant quatre portes ET $1305_1$, $1305_2$, $1305_3$ et $1305_4$ ayant chacune deux entrées binaires et une sortie binaire. Les portes ET $1305_1$, $1305_2$, $1305_3$ et $1305_4$ reçoivent, sur une première entrée, le signal BURST_ON, et, sur une deuxième entrée, respectivement les signaux PH1, PH2, PH3 et PH4 générés par le circuit 1301. Les sorties des portes ET $1305_1$, $1305_2$, $1305_3$ et $1305_4$ fournissent respectivement des signaux binaires PH1', PH2', PH3' et PH4'. Les signaux PH1', PH2', PH3' et PH4' sont identiques aux signaux PH1, PH2, PH3 et PH4 lorsque le signal BURST_ON est à l'état actif (état haut dans cet exemple), et sont à l'état bas lorsque le signal BURST_ON est à l'état inactif (état bas dans cet exemple).

Dans l'exemple de la figure 13, les signaux PH1', PH2', PH3' et PH4' sont destinés à commander les interrupteurs S1, S5, S2, S9, S3, S6, S14, S15, S18, S4, S10, S16, S17 et S19 en remplacement des signaux PH1, PH2, PH3 et PH4 des exemples des figures 8 et 9. Ainsi, lorsque le signal BURST_ON est à l'état haut, le convertisseur se comporte comme décrit précédemment, et acquiert des échantillons du signal d'entrée à la fréquence de sur-échantillonnage fCs du capteur. Lorsque le signal BURST_ON est à l'état bas, les interrupteurs S1, S5, S2, S9, S3, S6, S14, S15, S18, S4, S10, S16, S17 et S19 sont maintenus ouverts, de sorte que le convertisseur cesse d'acquérir des échantillons jusqu'à la prochaine activation du signal BURST_ON.

Selon une deuxième méthode d'amélioration de la résolution axiale dans un système du type décrit en relation avec la figure 3, on prévoit d'appliquer à l'onde ultrasonore d'excitation de l'échantillon une séquence aléatoire ou pseudo-aléatoire de sauts de phase de 0 ou $\pi$, à une fréquence fixant la résolution axiale du système. Cette même séquence de sauts de phase est aussi appliquée sur la voie de référence par l'intermédiaire du modulateur acousto-optique MAO1, avec un décalage temporel de durée $\tau$ par rapport à la séquence appliquée à l'onde ultrasonore. La portion d'échantillon vue par le système est alors celle dans laquelle la séquence de sauts de phase appliquée à l'onde ultrasonore coïncide temporellement avec la séquence de sauts de phase appliquée au faisceau de référence. Ainsi, la résolution axiale du système est approximativement égale à $\Delta t^* V_{US}$, où $\Delta t$ est la période d'application des sauts de phase et $V_{US}$ est la vitesse de propagation de l'onde ultrasonore dans l'échantillon analysé, et la distance entre l'émetteur ultrasonore et la portion de l'échantillon visible par le capteur est approximativement égale à $\tau^* V_{US}$.

Cette deuxième méthode peut être adaptée à un système du type décrit en relation avec la figure 5, dans lequel le capteur d'images est un capteur à sur-échantillonnage, et dans lequel la voie de référence ne comporte pas de modulateur acousto-optique. Une séquence aléatoire ou pseudo-aléatoire de sauts de phase de 0 ou $\pi$, à une cadence $1/\Delta t$ fixant la résolution axiale du système, est alors appliquée à l'onde ultrasonore. Toutefois, dans un tel système, la même séquence, déphasée d'une durée $\tau$ fixant la distance entre l'émetteur ultrasonore et la portion d'échantillon analysée, ne peut pas aisément être appliquée sur la voie de référence, cette dernière ne comportant pas de modulateur acousto-optique. Ainsi, on prévoit d'appliquer cette séquence dans le convertisseur à sur-échantillonnage lui-même, par l'intermédiaire d'une commande numérique. L'effet est alors le même que si la séquence de sauts de phase était appliquée sur la voie de référence.

La figure 14 est un schéma simplifié d'un circuit de commande d'un convertisseur analogique-numérique à sur-échantillonnage d'un capteur du type décrit en relation avec les figures 8 ou 9, adapté à recevoir un signal binaire aléatoire PHASE_JUMP représentatif d'une séquence de sauts de phase identique à celle appliquée sur l'onde ultrasonore, mais décalée de la durée $\tau$ par rapport à la séquence appliquée sur l'onde ultrasonore, et à commander des inversions de phase dans la séquence d'acquisition des échantillons du signal d'entrée à chaque fois que le signal PHASE_JUMP change d'état. Dans cet exemple, l'état haut du signal PHASE_JUMP correspond à un déphasage de $\pi$, et l'état bas du signal PHASE_JUMP correspond à un déphasage nul.

Comme dans l'exemple de la figure 13, le circuit de la figure 14 comprend un circuit 1301, cadencé par un signal d'horloge CLK, adapté à générer les signaux PH1, PH2, PH3 et PH4 de commande des interrupteurs d'un convertisseur à sur-échantillonnage du type décrit en relation avec la figure 8 ou 9.

Le circuit de la figure 14 comprend en outre un circuit d'inversion de phase 1403 comportant quatre multiplexeurs $1405_1$, $1405_2$, $1405_3$ et $1405_4$ de deux entrées vers une sortie. Le multiplexeur $1405_1$ reçoit respectivement sur ses première et deuxième entrées les signaux PH1 et PH3, le multiplexeur $1405_2$ reçoit respectivement sur ses première et deuxième entrées les signaux PH2 et PH4, le multiplexeur $1405_3$ reçoit respectivement sur

ses première et deuxième entrées les signaux PH3 et PH1, et le multiplexeur $1405_4$ reçoit respectivement sur ses première et deuxième entrées les signaux PH4 et PH2. Les multiplexeurs $1405_1$, $1405_2$, $1405_3$ et $1405_4$ fournissent respectivement sur leurs sorties des signaux binaires PH1', PH2', PH3' et PH4'. Chaque multiplexeur comprend en outre une entrée de sélection recevant le signal PHASE_JUMP. Les signaux PH1', PH2', PH3' et PH4' sont identiques aux signaux PH1, PH2, PH3 et PH4 lorsque le signal PHASE_JUMP est à l'état bas (déphasage nul), et les signaux PH1', PH2', PH3' et PH4' sont respectivement identiques aux signaux PH3, PH4, PH1 et PH2 lorsque le signal PHASE_JUMP est à l'état haut (déphasage égal à $\pi$). Ainsi, lorsque le signal PHASE_JUMP est à l'état haut, les phases de fonctionnement PH1 et PH3, respectivement PH2 et PH4 du convertisseur à sur-échantillonnage, sont interverties. On notera que, dans cet exemple, il convient de respecter une cohérence temporelle entre la fréquence $1/\Delta t$ d'application des sauts de phase, et les phases d'échantillonnage PH1, PH2, PH3 et PH4 des pixels.

Plus généralement, l'homme du métier saura adapter à d'autres structures de convertisseurs à sur-échantillonnage les méthodes susmentionnées d'amélioration de la résolution axiale du système.

Des modes de réalisation particuliers ont été décrits. Diverses variantes et modifications apparaîtront à l'homme de l'art.

En particulier, les modes de réalisation décrits ne se limitent pas aux exemples spécifiques de capteurs d'images à sur-échantillonnage décrits en relation avec les figures 8 et 9. Plus généralement, l'homme de l'art saura obtenir le fonctionnement recherché en utilisant d'autres architectures de capteurs d'images à sur-échantillonnage. L'homme de l'art saura en outre adapter les architectures décrites au cas où le rapport n entre la fréquence de battement $f_B$ du système et la fréquence de sur-échantillonnage $f_{Cs}$ du capteur est différent de 4, et où les formules de reconstruction du champ complexe du faisceau objet sont différentes des formules susmentionnées.

En outre, les modes de réalisation décrits ne se limitent pas aux exemples de plages de fréquences de fonctionnement mentionnées dans la présente description, l'étendue de l'invention étant définie par les revendications ci-jointes.

## Revendications

1. Système (400 ; 500) d'acquisition d'images par holographie numérique hétérodyne, comportant :

   un capteur d'images (409) ayant au moins une photodiode couplée à un convertisseur analogique-numérique à sur-échantillonnage (803 ; 903) ; et
   un montage optique permettant de projeter simultanément sur le capteur des premier (R) et deuxième (O) faisceaux lumineux cohérents de fréquences distinctes,

dans lequel le convertisseur (803 ; 903) est adapté à acquérir, à une première fréquence ($f_{Cs}$), des échantillons analogiques ($i1_i$, $i2_i$, $i3_i$, $i4_i$) représentatifs d'un signal de sortie de la photodiode, à produire, à une deuxième fréquence égale à la première fréquence ($f_{Cs}$) ou à un sous-multiple de la première fréquence ($f_{Cs}$), des premiers échantillons numériques d'une première résolution à partir desdits échantillons analogiques, et à fournir, à une troisième fréquence ($f_e$) égale à un sous-multiple de la deuxième fréquence, des deuxièmes échantillons numériques de résolution supérieure à la première résolution, générés à partir des premiers échantillons numériques,

et dans lequel la première fréquence ($f_{Cs}$) du convertisseur est égale à un nombre entier n de fois la fréquence de battement ($f_B$) du système, c'est-à-dire la valeur absolue de la différence entre les fréquences des premier (R) et deuxième (O) faisceaux.

2. Système (400) selon la revendication 1, dans lequel le montage optique comprend un unique modulateur acousto-optique (MAO1).

3. Système (500) selon la revendication 1, dans lequel le montage optique ne comprend pas de modulateur acousto-optique, et comprend une source ultrasonore d'excitation d'un objet (305) par lequel passe le deuxième faisceau lumineux (O).

4. Système (500) selon la revendication 3, dans lequel la source ultrasonore est adaptée à émettre une onde ultrasonore pendant un premier intervalle de temps de durée $\Delta t$, et dans lequel le convertisseur (803 ; 903) est adapté à n'acquérir des échantillons ($i1_i$, $i2_i$, $i3_i$, $i4_i$) représentatifs d'un signal de sortie de la photodiode que pendant un deuxième intervalle de temps de même durée $\Delta t$, décalé temporellement par rapport au premier intervalle de temps.

5. Système (500) selon la revendication 3, dans lequel la source ultrasonore est adaptée à émettre une onde ultrasonore présentant une première séquence aléatoire ou pseudo-aléatoire de sauts de phase de 0 ou $\pi$, et dans lequel le convertisseur est adapté à recevoir un signal binaire (PHASE_JUMP) représentatif d'une deuxième séquence de sauts de phase identique à la première séquence mais décalée temporellement par rapport à la première séquence, et à modifier une séquence de traitement des échantillons analogiques ($i1_i$, $i2_i$, $i3_i$, $i4_i$) en fonction de ce signal binaire.

6. Système (400 ; 500) selon l'une quelconque des revendications 1 à 5, dans lequel n est égal à 4.

7. Système (400 ; 500) selon l'une quelconque des revendications 1 à 6, dans lequel le convertisseur (803 ; 903) comprend un bloc d'échantillonnage analogique (821 ; 921) adapté à acquérir n échantillons analogiques (i1i, i2i, i3i, i4i) d'un signal de sortie de la photodiode à chaque période de battement ($T_B$) du système.

8. Système (400 ; 500) selon la revendication 7, dans lequel le bloc d'échantillonnage analogique (821 ; 921) est adapté à effectuer en analogique, à chaque période de battement ($T_B$) une ou plusieurs opérations arithmétiques à partir desdits échantillons (i1i, i2i, i3i, i4i).

9. Système (400 ; 500) selon la revendication 7 ou 8, dans lequel le convertisseur (803 ; 903) est adapté à fournir, après un nombre entier N de périodes de battement ($T_B$) du système, un premier signal numérique sur m bits, représentatif de la partie réelle du champ complexe du deuxième faisceau lumineux (O), et un deuxième signal numérique sur m bits, représentatif de la partie imaginaire du champ complexe du deuxième faisceau lumineux (O), ou m est un nombre entier supérieur ou égal à 1.

10. Système (400 ; 500) selon la revendication 9, dans lequel m est égal à $\log_2(N)$.

11. Système (400 ; 500) selon l'une quelconque des revendications 1 à 10, dans lequel le convertisseur (803) comprend un intégrateur (827) comportant deux capacités d'intégration.

12. Système (400 ; 500) selon l'une quelconque des revendications 1 à 10, dans lequel le convertisseur (903) comprend deux intégrateurs (927A, 927B) comportant chacun une capacité d'intégration.

13. Système (400 ; 500) selon l'une quelconque des revendications 1 à 12, dans lequel le capteur (409) comporte en outre un circuit (1003 ; 1103 ; 1203) de filtrage passe-haut entre la photodiode et le convertisseur (803 ; 903).

**Patentansprüche**

1. Ein System (400; 500) zum Erfassen von Bildern durch heterodyne digitale Holographie, aufweisend:

einen Bildsensor (409) mit wenigstens einer Fotodiode, die mit einem überabtastenden Analog-Digital-Wandler (803; 903) gekoppelt ist; und eine optische Anordnung, die es ermöglicht, auf den Sensor gleichzeitig erste (R) und zweite (O) kohärente Lichtstrahlen unterschiedlicher Frequenz zu projizieren,

wobei der Wandler (803; 903) geeignet ist zum Erfassen, mit einer ersten Frequenz ($f_{Cs}$), von analogen Abtastwerten ($i1_i$, $i2_i$, i3i, $i4_i$), die ein Ausgangssignal der Fotodiode darstellen, zum Erzeugen, mit bei einer zweiten Frequenz, die gleich der ersten Frequenz ($f_{Cs}$) oder einem Teiler bzw. Untervielfachen der ersten Frequenz ($f_{Cs}$) ist, von ersten digitalen Abtastwerten mit einer ersten Auflösung basierend auf den analogen Abtastwerten, und zum Bereitstellen, mit einer dritten Frequenz ($f_e$), die gleich einem Teiler bzw. Untervielfachen der zweiten Frequenz ist, von zweiten digitalen Abtastwerten mit einer Auflösung, die größer ist als die erste Auflösung, die aus den ersten digitalen Abtastwerten erzeugt werden,

und wobei die erste Frequenz ($f_{Cs}$) des Wandlers gleich einer ganzen Zahl n mal der Schwebungsfrequenz ($f_B$) des Systems ist, d.h. dem Absolutwert der Differenz zwischen den Frequenzen des ersten (R) und des zweiten (O) Strahlen.

2. System (400) nach Anspruch 1, wobei die optische Anordnung einen einzelnen akusto-optischen Modulator (MAO1) aufweist.

3. System (500) nach Anspruch 1, wobei die optische Anordnung keinen akustooptischen Modulator und eine Ultraschallquelle zur Anregung eines Objekts (305), das von dem zweiten Lichtstrahl (O) durchquert wird, aufweist.

4. System (500) nach Anspruch 3, wobei die Ultraschallquelle geeignet ist zum Emittieren einer Ultraschallwelle während eines ersten Zeitintervalls der Dauer $\Delta$t, und wobei der Wandler (803; 903) geeignet ist zum Erfassen von Abtastwerten ($i1_i$, i2i, i3$_i$, $i4_i$), die ein Ausgangssignal der Fotodiode darstellen, nur während eines zweiten Zeitintervalls der gleichen Dauer $\Delta$t, das bezüglich des ersten Zeitintervall zeitversetzt ist.

5. System (500) nach Anspruch 3, wobei die Ultraschallquelle geeignet ist zum Emittieren einer Ultraschallwelle mit einer ersten zufälligen oder pseudozufälligen Sequenz von Phasensprüngen von 0 oder $\pi$ auszusenden, und wobei der Wandler geeignet ist zum Empfangen eines binären Signals (PHASE_JUMP), das eine zweite Sequenz von Phasensprüngen darstellt, die mit der ersten Sequenz identisch ist, aber bezüglich der ersten Sequenz zeitversetzt ist, und zum Modifizieren eine analoge Abtastwert- ($i1_i$, i2i, i3$_i$, $i4_i$) Verarbeitungssequenz in Abhängigkeit von diesem binären Signal.

6. System (400; 500) nach einem der Ansprüche 1 bis 5, wobei n gleich 4 ist.

7. System (400; 500) nach einem der Ansprüche 1 bis 6, wobei der Wandler (803; 903) einen analogen Abtastblock (821; 921) aufweist, der geeignet ist zum Erfassen von n analogen Abtastwerten ($i1_i$, $i2_i$, $i3_i$, $i4_i$) eines Ausgangssignals der Fotodiode mit jeder Schwebungsperiode ($T_B$) des Systems.

8. System (400; 500) nach Anspruch 7, wobei der analoge Abtastblock (821; 921) geeignet ist zum analogen Ausführen für jede Schwebungsperiode ($T_B$) von einer oder mehreren arithmetischen Operation(en) basierend auf den Abtastwerten ($i1_i$, $i2_i$, $i3_i$, $i4_i$).

9. System (400; 500) nach Anspruch 7 oder 8, wobei der Wandler (803; 903) geeignet ist zum Bereitstellen, nach einer ganzzahligen Anzahl N von Schwebungsperioden ($T_B$) des Systems, eines ersten digitalen Signals über m Bits, das den Realteil des komplexen Feldes des zweiten Lichtstrahls (O) darstellt, und eines zweiten digitalen Signals über m Bits, das den Imaginärteil des komplexen Feldes des zweiten Lichtstrahls (O) darstellt, wobei m eine ganze Zahl größer oder gleich 1 ist.

10. System (400; 500) nach Anspruch 9, wobei m gleich $\log_2(N)$ ist.

11. System (400; 500) nach einem der Ansprüche 1 bis 10, wobei der Wandler (803) einen Integrator (827) mit zwei Integrationskondensatoren aufweist.

12. System (400; 500) nach einem der Ansprüche 1 bis 10, wobei der Wandler (903) zwei Integratoren (927A, 927B) aufweist, die jeweils einen Integrationskondensator aufweisen.

13. System (400; 500) nach einem der Ansprüche 1 bis 12, wobei der Sensor (409) ferner eine Hochpassfilterschaltung (1003; 1103; 1203) zwischen der Fotodiode und dem Wandler (803; 903) aufweist.

**Claims**

1. A system (400; 500) for acquiring images by heterodyne digital holography, comprising:

an image sensor (409) having at least one photodiode coupled to an oversampling analog-to-digital converter (803 ; 903); and
an optical assembly enabling to simultaneously project on the sensor first (R) and second (O) coherent light beams of different frequencies, wherein the converter (803; 903) is capable of acquiring, at a first frequency ($f_{Cs}$), analog samples ($i1_i$, $i2_i$, $i3_i$, $i4_i$) representative of an output signal of the photodiode, of generating, at a second frequency equal to the first frequency ($f_{Cs}$) or to a sub-multiple of the first frequency ($f_{Cs}$), first digital samples having a first resolution based on said analog samples, and of providing at a third frequency ($f_e$) equal to a sub-multiple of the second frequency second digital samples having a resolution greater than the first resolution, generated from the first digital samples, and wherein the first frequency ($f_{Cs}$) of the converter is equal to an integral number n of times the system beat frequency ($f_B$), that is, the absolute value of the difference between the frequencies of the first (R) and second (O) beams.

2. The system (400) of claim 1, wherein the optical assembly comprises a single acousto-optic modulator (MAO1).

3. The system (500) of claim 1, wherein the optical assembly comprises no acousto-optic modulator, and comprises an ultrasound source for exciting an object (305) crossed by the second light beam (O).

4. The system (500) of claim 3, wherein the ultrasound source is capable of emitting an ultrasound wave during a first time interval of duration $\Delta t$, and wherein the converter (803; 903) is capable of only acquiring samples ($i1_i$, $i2_i$, $i3_i$, $i4_i$) representative of an output signal of the photodiode during a second time interval of same duration $\Delta t$, time-shifted with respect to the first time interval.

5. The system (500) of claim 3, wherein the ultrasound source is capable of emitting an ultrasound wave having a first random or pseudo-random sequence of phase jumps by 0 or $\pi$, and wherein the converter is capable of receiving a binary signal (PHASE_JUMP) representative of a second sequence of phase jumps identical to the first sequence but time-shifted with respect to the first sequence, and of modifying an analog sample ($i1_i$, $i2_i$, $i3_i$, $i4_i$) processing sequence according to this binary signal.

6. The system (400; 500) of any of claims 1 to 5, wherein n is equal to 4.

7. The system (400; 500) of any of claims 1 to 6, wherein the converter (803 ; 903) comprises an analog sampling block (821; 921) capable of acquiring n analog samples (i1i, i2i, i3i, i4i) of an output signal of the photodiode at each beat period ($T_B$) of the system.

8. The system (400; 500) of claim 7, wherein the analog sampling block (821; 921) is capable of analogically performing, for each beat period ($T_B$), one or a plurality of arithmetic operations based on said samples (i1i, i2i, i3i, i4i).

9. The system (400; 500) of claim 7 or 8, wherein the converter (803; 903) is capable of providing, after an integral number N of beat periods ($T_B$) of the system, a first digital signal over m bits, representative of the real part of the complex field of the second light beam (O), and a second digital signal over m bits, representative of the imaginary part of the complex field of the second light beam (O), where m is an integer greater than or equal to 1.

10. The system (400; 500) of claim 9, wherein m is equal to $\log_2(N)$.

11. The system (400; 500) of any of claims 1 to 10, wherein the converter (803) comprises an integrator (827) comprising two integration capacitors.

12. The system (400; 500) of any of claims 1 to 10, wherein the converter (903) comprises two integrators (927A, 927B) each comprising an integration capacitor.

13. The system (400; 500) of any of claims 1 to 12, wherein the sensor (409) further comprises a high-pass filtering circuit (1003; 1103; 1203) between the photodiode and the converter (803; 903).

$(f_c = n*(f_{MAO2} - f_{MAO1}))$

Fig 1

$(f_c = n*(f_{MAO2}+f_{US} - f_{MAO1}))$

Fig 3

Fig 2

400

101 L

103

R
($f_L$)

107

409

MAO1   O
($f_L + f_{MAO1}$)

105
OBJ

($f_{cs} = n*f_{MAO1})$)

**Fig 4**

500

101 L

103

R
($f_L$)

107

409

O

US

($f_{cs} = n*f_{US}$)

($f_L$)

305

($f_L + f_{US}$)

**Fig 5**

600

601

603

605

IN

ΔΣ
MODULATOR

1bit
($f_s$)

FILTER

pbits
($f_s$)

DECIMATOR

mbits
($f_e$)

OUT

**Fig 6A**

611

613

$f_s$

IN

+
−

$V_{REF}$

1b-ADC

1bit

615

617
1b-DAC

601

**Fig 6B**

**Fig 7**

**Fig 8**

**Fig 9**

**Fig 10**

**Fig 11**

Fig 12

BURST_ON

1303

CLK    1301

PH1
PH2
PH3
PH4

1305₁ → PH1'

1305₂ → PH2'

1305₃ → PH3'

1305₄ → PH4'

**Fig 13**

PHASE_JUMP

1403

CLK    1301

PH1
PH2
PH3
PH4

PH1
PH3 → PH1'
1405₁

PH2
PH4 → PH2'
1405₂

PH3
PH1 → PH3'
1405₃

PH4
PH2 → PH4'
1405₄

**Fig 14**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 1363761